(19) Europäisches Patentamt

European Patent Office

Office européen des brevets

(11) **EP 1 516 164 B1**

(12) **EUROPÄISCHE PATENTSCHRIFT**

(45) Veröffentlichungstag und Bekanntmachung des Hinweises auf die Patenterteilung:
**02.11.2005 Patentblatt 2005/44**

(51) Int Cl.⁷: **G01J 1/00**

(21) Anmeldenummer: 03727495.8

(22) Anmeldetag: **22.05.2003**

(86) Internationale Anmeldenummer:
**PCT/EP2003/005379**

(87) Internationale Veröffentlichungsnummer:
**WO 2003/100365 (04.12.2003 Gazette 2003/49)**

(54) **OPTIKERFASSUNGSVORRICHTUNG**

OPTICAL DETECTION DEVICE

DISPOSITIF DE DETECTION OPTIQUE

(84) Benannte Vertragsstaaten:
**AT BE BG CH CY CZ DE DK EE ES FI FR GB GR HU IE IT LI LU MC NL PT RO SE SI SK TR**

(30) Priorität: **24.05.2002 DE 10223201**

(43) Veröffentlichungstag der Anmeldung:
**23.03.2005 Patentblatt 2005/12**

(73) Patentinhaber:
• **Frauenhofer-Gesellschaft zur Förderung der angewandten Forschung e.V.**
  **80686 München (DE)**
• **DEUTSCHE THOMSON-BRANDT GMBH**
  **30625 Hannover (DE)**

(72) Erfinder:
• **HEHEMANN, Ingo**
  **49170 Hagen (DE)**

• **BROCKHERDE, Werner**
  **47259 Duisburg (DE)**
• **KEMNA, Armin**
  **47051 Duisburg (DE)**
• **HOFMANN, Holger**
  **Thousand Oaks, CA, 91320 (US)**
• **RICHTER, Hartmut**
  **78052 Villingen-Schwenningen (DE)**

(74) Vertreter: **Schoppe, Fritz**
**Patentanwälte**
**Schoppe, Zimmermann, Stöckeler & Zinkler**
**Postfach 246**
**82043 Pullach bei München (DE)**

(56) Entgegenhaltungen:
**EP-A- 0 405 670**       **EP-A- 0 556 000**
**EP-A- 1 028 412**       **US-A- 5 566 151**
**US-A- 5 701 283**       **US-A- 5 774 432**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung bezieht sich auf Optikerfassungseinrichtungen, wie z.B. auf optische Abtaster oder Pick-up-Systeme in CD- (compact disc) und DVD- (digital versatile disc) Geräten oder optische Empfänger in optischen Übertragungsstrecken.

Angetrieben durch die steigenden multimedialen Ansprüche hinsichtlich Photo, Audio und Video besteht derzeit ein exponentielles Wachstum an Speicherbedarf. Optische Speichersysteme stellen hierbei eine besonders attraktive Lösung zwischen magnetischen Bandspeichermedien und Festplatten dar. Mit Zugriffszeiten im Millisekundenbereich, welche nur geringfügig über denen einer Festplatte liegen, bieten optische Speichersysteme die Möglichkeit zum alltäglichen Einsatz beim Endverbraucher. Mit Bandlaufwerken teilen dieselben die Eigenschaft der Archivierbarkeit, d.h. die Eigenschaft, daß das Speichermedium im Laufwerk ausgewechselt werden kann.

Derzeitige Speicherkapazitäten von ca. 5 Gigabyte und kurzfristige Prognosen von bis zu 50 Gigabyte machen optische Speichermedien auch im Videorekorderbereich konkurrenzfähig, so daß ein starkes Wachstum auf diesem Sektor als sicher erscheint. All diesen optischen Speichern gemein ist, daß sowohl der Schreibvorgang als auch die Auslese der auf dem Speichermedium gespeicherten Daten mittels eines Lichtstrahls erfolgt, und daß bei der Auslese ein durch das Speichermedium gemäß den darauf gespeicherten Daten modifizierter, z.B. reflektierter, transmittierter oder polarisierter, Lichtstrahl durch einen optoelektronischen Detektor in ein elektrisches Signal umgewandelt wird.

Weitere Einsatzgebiete solcher optoelektronischen Detektoren liegen beispielsweise im Bereich der optischen Übertragung, wie z.B. in Form eines Detektorarrays bei parallelen Übertragungsstrecken.

Bei all diesen Anwendungen für optische Detektoren besteht ein Problem darin, den optischen Detektor fest zu dem zu erfassenden Lichtstrahl anzuordnen, damit sich der Lichtstrahl in optimaler Ausrichtung zu dem optischen Detektor befindet. Dies bedingt beispielsweise eine aufwendige und teuere, da präzise, Justage beim Aufbau des optischen Gerätes, in dem der optische Detektor verwendet wird, oder aufwendige Vorkehrungen gegen thermische Driften oder andere anwendungsspezifische Betriebsvorfälle, wie z.B. Vorkehrungen gegen Fehlausrichtung des Lichtstrahls relativ zum optischen Detektor oder andere die Auslese negativ beeinflussende Faktoren.

Ein Beispiel solcher optischer Geräte sind CD- und DVD-Geräte. Diese umfassen einen Lesekopf, der die Aufgabe hat, die Daten vom Speichermedium CD bzw. DVD abzutasten und zurückzugewinnen. Neben einer Laserdiode, einer Optik aus optischen Bauelementen, Fokusregel- und Spurregel-Aktuatoren, besteht der Lesekopf aus einer Photodiodenmatrix, die neben der Auslese von Daten Signale zur Fokus- und Spurregelung liefert. Eine Photodiodenmatrix üblichen Aufbaus ist beispielsweise in Fig. 12 gezeigt und wird beispielsweise in dem Artikel von M. O. Freeman et al. mit dem Titel "Robust Focus and Tracking Detection for Holographic Digital Versatile Disc Optical Pickup-Head Modules" in Jpn. Journal of Applied Physics, 1999, S. 1755-1760, beschrieben. Die in Fig. 12 gezeigte Diodenmatrix besteht aus vier Empfangsdioden 900, 902, 904 und 906, die mit A, B, C und D bezeichnet sind und in einer ebenen 2x2-Matrix angeordnet sind. Das Diodenarray von Fig. 12 ist in dem Lesekopf des CD- oder DVD-Gerätes angeordnet, um einen von einer Spur auf der CD bzw. DVD reflektierten Lichtstrahl zu empfangen. In dem Fall einer CD sind die Daten in der Spur der optischen Platte beispielsweise durch eine vorbestimmte Aufeinanderfolge von ebenen Stellen und Erhöhungen (bzw. Vertiefungen je nach Betrachtungsweise) (sogenannten Pits) gespeichert. Der auf die Platte treffende und von derselben reflektierte Lichtstrahl ist breiter als die Spur bzw. die Pits, so daß die Erhöhungen bei der Reflexion des darauf fokussierten Lichtstrahls zu einer destruktiven Interferenz des reflektierten Lichtstrahls führen, so daß die Erhöhungen durch reduzierten Lichtintensität des reflektierten Strahls und ebene Stellen durch höhere bzw. maximale Lichtintensität erkennbar sind. Die Optik bildet den reflektierten Lichtstrahl auf das Diodenarray ab. Aus den Ausgangssignalen der Empfangsdioden 900-906 wird das Datensignal, aus denen die in der Spur gespeicherten Daten gewonnen werden, durch Summieren aller Ausgangssignale dieser Dioden gewonnen, d. h. durch Verrechnung von A + B + C + D. Aufgrund der immer schnelleren Auslese und der immer höher werdenden Datendichte müssen die Empfangsdioden 900-906 Dioden sein, die für eine schnelle Auslese geeignet sind. Derartige Dioden werden im folgenden als HF-Dioden bezeichnet. Der Grund, wieso mehr als eine, nämlich vier HF-Dioden 900-906 vorgesehen sind, besteht darin, daß die Intensitätsverteilungsinformationen, die aus diesen HF-Dioden erhalten werden können, zur Fokus- und Spurregelung verwendet werden. Zur Fokusregelung wird beispielsweise der auf die optische Platte fokussierte und von derselben zurückreflektierte Lichtstrahl über eine astigmatische, wie z.B. zylindrische, Linse auf das Diodenarray von Fig. 12 abgebildet. Der Sollabstand zwischen Lesekopf und optischer Platte wird dabei derart festgelegt, daß sich auf dem Diodenarray von Fig. 12 eine kreisförmige Abbildung des auf die optische Platte fokussierten Lichtstrahls ergibt. In dem Fall einer Defokussierung ergibt sich eine elliptische Verformung des auf das Diodenarray von Fig. 12 abgebildeten Lichtflecks in eine der Hauptachsen der astigmatischen Linse. Für die Abstands- bzw. Fokusregelung werden deshalb die Ausgangssignale der Dioden 902 und 904 und der Dioden 900 und 904 zusammenaddiert und die Summen voneinander abgezogen, d.h. (A+C) - (B+D), um die elliptische Verformung bei Defokussierung zu erfassen, wobei angenommen wird, daß die Hauptachsen der astigmatischen Linse entlang der in Fig. 12 angezeigten Achsen x und y verlaufen. Bei Ausrichtung der astigmatischen Linse mit der starkbrechenden Achse entlang der Achse x zeigt eine elliptische Ausdehnung entlang der Hauptachse y beispielsweise einen größeren Abstand als den Sollabstand an, während eine elliptische Ausdehnung entlang der Achse x beispielsweise einen zu kleinen Abstand anzeigt. Entsprechend des Fokusregelungssignals kann dann der Abstand der Objektivlinse zur optischen Platte durch einen Aktuator verstellt werden. Auf ähnliche Weise kann zur Spurregelung des Lasers auf dem Datenträger, d.h. zur radialen Bewegung des Lesekopfes über die sich drehende optische Platte, das Signal (A+D) - (C+B) genutzt werden. Diese Verknüpfung der Dioden ist geeignet um das sogenannte Pushpull-Muster zu erfassen, das durch Interferenz von Brechungsordnungen bewirkt wird, die durch die Erhöhungen erzeugt werden, die wie ein Phasengitter wirken.

Eine weitere Möglichkeit zur Bereitstellung eines Signals zur Spurregelung, d.h. zur Einstellung der radialen Position des Lesekopfes bzw. der Position des Lesekopfes in Richtung quer zur Spur, besteht in der Anordnung zweier zusätzlicher Empfangsdioden außerhalb des eigentlichen HF-Diodenarrays. Einen solchen Aufbau zeigt Fig. 13. Wie es zu sehen ist, sind neben den vier HF-Dioden 900-906 zwei Empfangdioden 908 und 910 vorgesehen. Da die Spurregelung eine nicht zu hohe Abtast- bzw. Ausleserate erfordert, werden diese Empfangsdioden weniger schnell ausgelesen, wobei Erfassungsdioden zur langsameren Auslese im folgenden als LF-Dioden bezeichnet werden. Diese LF-Dioden 908 und 910 sind vorgesehen, um zwei zusätzlich zu dem eigentlichen Datenausleselichtstrahl auf die optische Platte fokussierte und reflektierte Lichtstrahlen zu empfangen. Diese zusätzlichen Lichtstrahlen werden beispielsweise aus dem eigentlichen zur Datenauslese verwendeten Laserdiodenstrahl durch Beugung als die erste Beugungsordnung erhalten und sind derart relativ zu dem Hauptstrahl angeordnet, daß sie etwas vor und hinter dem Hauptlichtstrahl relativ zur Spurrichtung und leicht quer zur Spurrichtung auf die optische Platte fokussiert werden. In dem Fall, daß der Lesekopf optimal mit der Spur ausgerichtet ist, werden aufgrund der endlichen Ausdehnung der fokussierten zusätzlichen Lichtstrahlen auf der optischen Platte beide zusätzlichen Lichtstrahle durch die Pits der Spur moduliert. In dem Fall einer lateralen Spurfehlausrichtung des Lesekopfes, liegt nur die endliche Ausdehnung einer der zusätzlichen Lichtstrahlen in der Spur, während der andere zusätzliche Lichtstrahl nicht moduliert wird. Aus diesen Informationen lassen sich Spurregelsignale zur radialen Steuerung des Lesekopfes herleiten.

Beide Diodenanordnungen von Fig. 12 und Fig. 13 haben gemeinsam, daß sie empfindlich gegenüber nicht idealer Positionierung des Lichtstrahls aufgrund von Fehljustierungen bzw. thermische Driften sind. Außerdem wirken sich optische Offset aufgrund von optischen Substratdickevariationen auf dem Speichermedium und Verkippungen der optischen Platte von einer Sollage negativ auf die Fehlerrate der rückgewonnenen Daten aus, da diese Vorfälle nicht detektiert werden können. Das Resultat ist ein aufwendiger Fertigungsprozeß, der diese Fehlerquellen mittels genauer Justage, teuerer Komponenten und einer Aufwendigeren Spur- und Fokusregelung eliminiert.

Zusätzliche Probleme ergeben sich aus den immer größer werdenden Anforderungen an die Speicherdichte und Kompaktheit der optischen Speicherplatte. Aufgrund der endlichen Ausdehnung des Laserspots kommt es mit zunehmender Speicherdichte zu Crosstalk- bzw. Übersprecherscheinungen durch die gleichzeitige Auslese zweier benachbarter Spuren auf dem Datenträger. Bisherige Detektoren bieten keine Möglichkeit, dies zu detektieren. Das resultiert wiederum in erhöhten Fehlerraten, da beispielsweise ein Pit auf der Nachbarspur bei Vorliegen keines Pits auf der auszulesenden Spur zu einem falschen Ausleseergebnis führen kann, und beschränkt zugleich den Spurabstand auf dem Datenträger, der wiederum entscheidend die Speicherkapazität des Mediums bestimmt.

Ein Nachteil an den früheren Diodenstrukturen besteht zudem in dem hohen Aufwand, um aus dem empfangenen Lichtstrahl Informationen über eine Fehlausrichtung bzw. Korrektursignale für eine solche zu erhalten. Das Unterteilen des Empfangsfenster in vier Teile, d.h. in die HF-Dioden 900-906, vervierfacht beispielsweise den Ausleseaufwand dieser Dioden, der für jede dieser Dioden ja für Auslesegeschwindigkeiten ausgelegt sein muß, die für die Auslese von Daten geeignet ist. In dem Fall von Fig. 13 setzen die zur Spurregelung verwendeten LF-Dioden 908 und 910 den zusätzlichen optischen Aufwand zweier Strahlen einer ersten Beugungsordnung voraus.

Es ist die Aufgabe der vorliegenden Erfindung eine Optikerfassungseinrichtung und ein Verfahren zum Betreiben derselben zu schaffen, so daß neben der Erfassung von durch den Lichtstrahl übertragenen Daten eine effektivere Form zur optimalen Ausrichtung des Lichtstrahls mit der Optikerfassungseinrichtung ermöglicht wird.

Diese Aufgabe wird durch eine Optikerfassungseinrichtung gemäß Anspruch 1 und ein Verfahren gemäß Anspruch 16 gelöst.

Eine erfindungsgemäße Optikerfassungseinrichtung zum Erfassen einer Intensität eines Lichtstrahls in einem Erfassungsfenster und zum Erfassen von durch den Lichtstrahl übertragenen Daten umfaßt eine erste Erfassungsdiode und ein Array von mindestens zwei zweiten Erfassungsdioden in dem Erfassungsfenster. Es ist ferner eine erste Ausleseschaltung vorgesehen, die mit der ersten Erfassungsdiode verbindbar ist, zum Auslesen der ersten Erfassungsdiode mit einer ersten Auslesegeschwindigkeit, um die Daten zu erfassen, sowie eine zweite Ausleseschaltung, die mit den zweiten Erfassungsdioden verbindbar ist, zum Auslesen der zweiten Erfassungsdioden mit einer zweiten Auslesegeschwindigkeit, die kleiner als die erste Auslesegeschwindigkeit ist, um die z.B. gemittelte Intensität des Lichtstrahls zu erfassen.

Die Erkenntnis der vorliegenden Erfindung besteht darin, daß von der bisherigen Art und Weise des Aufbaus von Optikerfassungsvorrichtungen, die entweder zusätzlich erzeugte Lichtstrahlen außerhalb des zur Datenerfassung verwendeten Erfassungsfensters zur Regelung der Ausrichtung des die Daten übertragenden Lichtstrahles mit den zur Erfassung der Daten verwendeten Erfassungsdioden verwendeten oder die zur Erfassung der Daten verwendeten Erfassungsdioden innerhalb der Erfassungsfensters selbst zur Steuerung der Ausrichtung vorsahen, abgegangen werden muß, um eine Verringerung des Aufwands zur Ausrichtungssteuerung zu erzielen. Erfindungsgemäß wird dies dadurch gelöst, daß in demselben Erfassungsfenster, in welchem der die Daten übertragende Lichtstrahl erfaßt werden soll, nicht nur eine zur Erfassung der Daten verwendete Erfassungsdiode sondern auch ein Array von zusätzlichen Erfassungsdioden vorgesehen wird, die mit einer kleineren Auslesegeschwindigkeit ausgelesen werden.

Eine der vorliegenden Erfindung zugrundeliegende Überlegung besteht darin, daß das Vorsehen zusätzlicher Erfassungsdioden in dem Erfassungsfenster zwar zunächst einen zusätzlichen Aufwand und eine Redzierung der zur Datenerfassung effektiv nutzbaren Fläche des Erfassungsfensters bedeutet, daß diese Nachteile aber dadurch überwogen werden, daß dieses Array von zusätzlichen Erfassungsdioden in dem Erfassungsfenster effektivere bzw. unaufwendigere Steuerungen der Ausrichtung des die Daten übertragenden Lichtstrahles mit dem Erfässungsfenster ermöglicht. So ist es beispielsweise in den meisten Fällen nicht erforderlich, zur Steuerung der Ausrichtung des Lichtstrahles mit dem Erfassungsfenster die Intensität des Lichtstrahles in dem Erfassungsfenster mit derselben Auslesegeschwindigkeit zu erfassen wie die zumeist hohe Datenrate, mit der die Daten übertragen werden. Diese langsamere, da lediglich auf die Ausrichtung des Lichtstrahls mit dem Erfassungsfenster ausgelegte Auslesegeschwindigkeit ermöglicht aber wiederum, daß die zusätzlich eingefügten Erfassungsdioden flächenmäßig kleiner sein können, da sie das erfaßte Licht über einen längeren Zeitraum hinweg integrieren bzw. aufsummieren können. Aufgrund der langsameren Auslese des Arrays von zusätzlichen Erfassungsdioden ist zudem der Ausleseaufwand dieser Erfassungsdioden geringer und ein gemultiplexter Auslesebetrieb dieses Arrays ist möglich, wodurch zur Auslese des zusätzlichen Arrays beispielsweise lediglich ein zusätzlicher Ausgang bzw. ein zusätzlicher Pin erforderlich ist. Ferner ist es aufgrund der Tatsache, daß die zusätzlichen Dioden direkt in dem Erfassungsfenster, das zur Erfassung des die Daten übertragenden Lichtstrahls vorgesehen ist, angeordnet sind, nicht erforderlich, zusätzliche Lichtstrahlen neben dem die Daten übertragenden Lichtstrahl zu erzeugen. Da über die räumliche Intensitätsverteilung des die Daten übertragenden Lichtstrahls in dem Erfassungsfenster, die durch das Array von zusätzlichen Erfassungsdioden erfaßt wird, die Ausrichtung des Lichtstrahls mit dem Erfassungsfenster gesteuert werden kann, ist es nicht erforderlich, die zur Datenerfassung verwendete Fläche des Erfassungsfensters in mehrere Teile zu unterteilen, so daß lediglich eine schnelle und damit aufwendigere Ausleseschaltung erforderlich ist. Zudem ermöglicht die Erfassung der Intensität des die Daten übertragenden Lichtstrahles in dem Erfassungsfenster selbst durch ein Array von zusätzlichen Erfassungsdioden die Bestimmung des Intensitätsschwerpunktes, welche Information wiederum in vielen Anwendung zur alternativen Regelungen zur Ausrichtung des Lichtstrahls mit dem Erfassungsfenster verwendet werden können.

Gemäß einem speziellen Ausführungsbeispiel der vorliegenden Erfindung wird eine spezielle Optikerfassungsvorrichtung sowie ihre vorteilhafte Anwendung in CD- und DVD-Geräten beschrieben.

Weitere bevorzugte Ausgestaltungen der vorliegenden Erfindung sind in den abhängigen Ansprüchen definiert.

Bevorzugte Ausführungsbeispiele der vorliegenden Erfindung werden nachfolgend Bezug nehmend auf die beiliegenden Zeichnungen näher erläutert. Es zeigen:

Fig. 1        in schematischer Darstellung eine Optikerfassungsvorrichtung gemäß einem Ausführungsbeispiel der vorliegenden Erfindung;

Fig. 2a       in schematischer Darstellung eine Erfassungsdiodenanordnung einer optischen Abtastvorrichtung gemäß einem Ausführungsbeispiel der vorliegenden Erfindung;

Fig. 2b       ein Blockdiagramm des Auslese- und Steuerungsteils der optischen Abtastvorrichtung von Fig. 2a;

Fig. 3a       ein exemplarisches Layout für die Diodenanordnung von Fig. 2 gemäß einem speziellen Ausführungsbeispiel der vorliegenden Erfindung;

Fig. 3b       eine Schnittebene durch das Layout von Fig. 3a;

Fig. 4        ein Simulationsergebnis für den Dunkelstrom, der sich entlang der Schnittebene von Fig. 3b bei dem Layout von Fig. 3a einstellt;

Fig. 5        einen Graphen, der die Flächen- und Umfangskapazität der HF- und LF-Dioden in der Diodenanordnung von Fig. 3a in Abhängigkeit von der Diodenspannung zeigt, um den verbesserten Kapazitätsbelag von Fläche und Rand darzustellen;

Fig. 6        einen Graphen, der die Übergangskapazität einer HF-Diode der Diodenanordnung gemäß Fig. 3a in Abhängigkeit von der Diodenspannung zeigt;

Fig. 7    einen Graphen, der die Übergangskapazität einer LF-Diode der Diodenanordnung gemäß Fig. 3a in Abhängigkeit von der Diodenspannung zeigt;

Fig. 8    einen Graphen, der die spektrale Antwort der Dioden der Diodenanordnung gemäß Fig. 3a bei gleichzeitiger Auslese zeigt;

Fig. 9    eine Ausleseschaltung zum Auslesen der HF-Dioden des Ausführungsbeispiels von Fig. 2;

Fig. 10    ein Ausführungsbeispiel für eine Verstärkerschaltung für den Verstärker von Fig. 9;

Fig. 11a    eine Ausleseschaltung der Auslese der LF-Dioden des Ausführungsbeispiels von Fig. 2;

Fig. 11b    exemplarische Zeitverläufe von Signalen, die bei der Schaltung von Fig. 11a auftreten, zur Verdeutlichung des kaskadenhaften Auslesens der LF-Dioden;

Fig. 12    ein herkömmliches HF-Diodenarray, wie es bei CD- und DVD-Geräten eingesetzt wird; und

Fig. 13    eine alternative Diodenanordnung zu der von Fig. 12 mit zusätzlichen LF-Dioden zur Spurregelung.

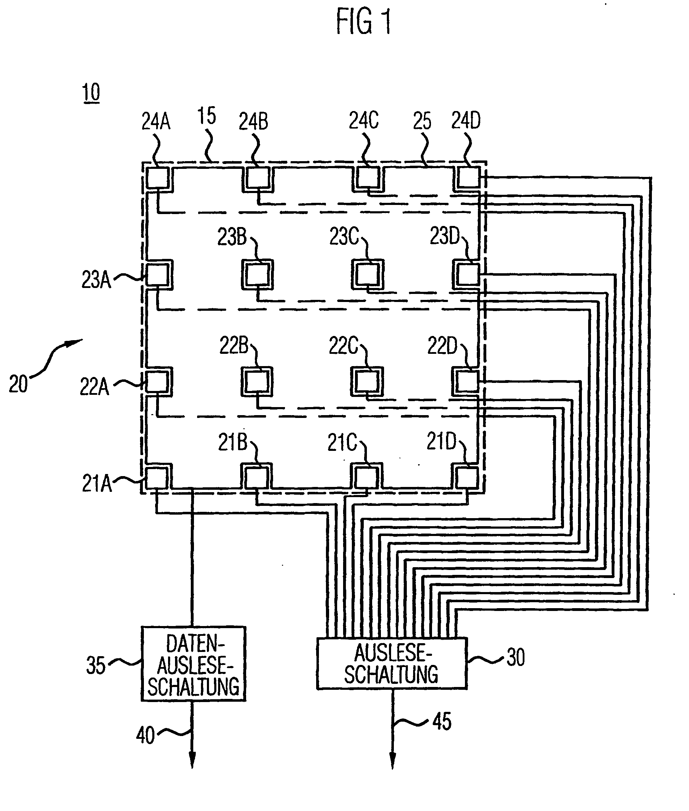

Fig. 1 zeigt zunächst eine Optikerfassungsvorrichtung gemäß einem Ausführungsbeispiel der vorliegenden Erfindung, die allgemein mit 10 angezeigt ist. Die Optikerfassungsvorrichtung 10 umfaßt in einem Erfassungsfenster 15, welches zur Erfassung eines Daten übertragenden Lichtstrahls vorgesehen ist, ein 4x4-Array 20 von Erfassungsdioden 21a, 21b, 21c, 21d, 22a, 22b, 22c, 22d, 23a, 23b, 23c, 23d, 24a, 24b, 24c, 24d, wobei jeweils die zweite Ziffer eine Zeilennummer und der Buchstabe eine Spaltennummer angibt. Ferner umfaßt die Optikerfassungsvorrichtung 10 eine Erfassungsdiode 25, die flächenmäßig den nicht durch das Diodenarray 20 eingenommenen Flächenanteil des Erfassungsfenster 15 einnimmt bzw. abdeckt. Die Erfassungsdioden 21a-24d sind mit einer Ausleseschaltung 30 verbunden, während die Erfassungsdiode 25 mit einer Datenausleseschaltung 35 verbunden ist. Die Auslesegeschwindigkeit der Ausleseschaltungen 30 und 35 sind unterschiedlich. Die Datenausleseschaltung 35 besitzt eine ausreichend hohe Auslesegeschwindigkeit, um die in dem Lichtstrahl, der durch die Optikerfassungsvorrichtung in dem Erfassungsfenster 15 erfaßt werden soll, übertragenen Daten ausreichend schnell abtasten zu können. Die Datenausleseschaltung 35 gibt das Auslesesignal in analoger Form an einem Ausgang 40 aus, wobei sich an dieselbe ein A/D-Wandler anschließen kann (nicht gezeigt). Die Ausleseschaltung 30 liest die Erfassungsdioden 21a-24d mit einer geringeren Auslesegeschwindigkeit aus, und gibt die ausgelesenen Werte beispielsweise seriell in analoger Form an einem Ausgang 45 aus. Alternativ können beide Auslesevorrichtungen 30 und 35 bereits digitale Abtastwerte ausgeben.

Basierend auf den durch das Diodenarray 20 erfaßte Intensitätsverteilung des auf das Erfassungsfenster 15 einfallenden Lichtstrahls an den Orten der Erfassungsdioden 21a-24d können geeignete Maßnahmen zur Korrektur einer Fehljustierung bzw. Fehlausrichtung des Lichtstrahls mit dem Erfassungsfenster 15 ergriffen werden, wie es im folgenden näher erörtert werden wird.

Die Optikerfassungsvorrichtung 10 von Fig. 1 gliedert sich im wesentlichen in zwei Teile. Der eine, aus der Erfassungsdiode 25 und der Datenausleseschaltung 35 bestehende Teil ist für die Datenerfassung zuständig. Die Erfassungsdiode 25 muß eine ausreichend hohe Bandbreite besitzen, um eine Auslesegeschwindigkeit zu ermöglichen, die an die Datenrate angepaßt ist, mit der die Daten in dem in dem Erfassungsfenster 15 zu erfassenden Lichtstrahl übertragen werden.

Der zweite Teil der Optikerfassungsvorrichtung 10 besteht aus dem Diodenarray 20 und der Ausleseschaltung 30. Dieser Teil ist dafür zuständig, Informationen bereitzustellen, die eine optimale Ausrichtung zwischen dem Erfassungsfenster 15 und dem die Daten übertragenden Lichtstrahl ermöglichen. Mögliche Fehlausrichtungen des Lichtstrahls zu dem Erfassungsfenster 15 können beispielsweise durch eine Fehljustage bei dem Zusammenbau des optischen Gerätes (nicht gezeigt), in welches die Optikerfassungsvorrichtung 10 eingebaut ist, durch thermische Driften, durch mechanische Stöße während des Betriebes in dem Fall, daß die Optikerfassungsvorrichtung beispielsweise in einem tragbaren CD-Player eingebaut ist, oder durch anwendungsbedingte Regelvorgänge im Zusammenhang mit der Auslese, wie z.B. bei der Spurfolgung oder Fokussierung, bedingt sein. Im Vergleich zur hohen Datenrate bzw. der hohen Auslesegeschwindigkeit sind die Änderungen in der Ausrichtung zwischen Lichtstrahl und Erfassungsfenster 15 erfahrungsgemäß langsam, so daß für die Ausleseschaltung 30 eine langsamere Auslesegeschwindigkeit im beispielsweise kHz-Bereich ausreichend ist. Das von der Ausleseschaltung 30 an dem Ausgang 45 ausgegebene gemultiplexte Signal, das die Intensität des Lichtstrahls am Ort der Dioden 21a-24d anzeigt, kann beispielsweise dazu verwendet werden, den Intensitätsschwerpunkt bzw. die Strahlmitte des Lichtstrahls in dem Erfassungsfenster 15 zu bestimmen, der bzw. die im folgenden auch als die Ist-Position des Lichtstrahls in dem Erfassungsfenster 15 bezeichnet wird. Möglichkeiten, die Ist-Position des Lichtstrahls in dem Erfassungsfenster 15 zu bestimmen, umfassen beispielsweise, aber nicht ausschließend, eine Bestimmung derjeniger Erfassungsdiode unter den Erfassungsdioden 21a-24d, die die maximale Intensität erfaßt, eine Interpolation und anschließende Extremalauswertung der durch die Erfassungsdioden 21a-24d erfaßten Intensitätsverteilung, die Berechnung eines Intensitätsfitverlaufes durch die durch die Erfassungsdioden 21a-24d erfaßten Intensitätswerte mit anschließender Extremalauswertung oder dergleichen.

Ferner können die aus den Erfassungsdioden 21a-24d gewonnenen Informationen dazu verwendet werden, eine elliptische Entartung der Intensitätsverteilung des Lichtstrahls in dem Erfassungsfenster 15 zu erfassen, die sich beispielsweise durch Verwendung einer astigmatischen Linse ergibt. Ferner können spezielle Verschaltungen von einigen der Erfassungsdioden 21a-24d, die an speziellen Positionen angeordnet sind, wie z.B. einer Addition oder Subtraktion derselben, verwendet werden, um Fehlausrichtungen entgegenzuwirken bzw. geeignete Steuersignale für anwendungsspezifische Ereignisse zu erzeugen, die bedingt durch diese Fehlausrichtungen zu charakteristischen Intensitätsverteilungen an diesen speziellen Positionen führen.

Bezugnehmend auf Fig. 1 wird darauf hingewiesen, daß dieses Ausführungsbeispiel einer Optikerfassungsvorrichtung in verschiedensten optischen Geräten eingesetzt werden kann, in denen die Erfassung eines Daten übertragenden Lichtstrahls vorgesehen ist. Beispiele solcher Geräte umfassen optische Speichergeräte, wie z.B. CD- oder DVD-Geräte, aber auch Geräte, in denen optische Übertragungsstrecken zum Verbindung zweier elektronischen Vorrichtungen vorgesehen sind. Je nach Anwendung können die unterschiedlichsten Aktuatoren verwendet werden, um die Fehlausrichtung des Lichtstrahls in dem Erfassungsfenster zu korrigieren. In dem Fall von CD- und DVD-Geräten umfassen mögliche durch Aktuatoren einstellbare Parameter zur Beeinflussung der Ausrichtung des Laserstrahls in dem Erfassungsfenster beispielsweise die radiale Position des Lesekopfes in Richtung quer zur Spur, den Abstand der Objektivlinse von der optischen Platte, und eine beispielsweise piezoelektrische laterale Verschiebung des Erfassungsfensters samt darin enthaltender Diodenanordnung, um auch statische Fehljustierungen oder thermische Driften korrigieren zu können.

In all diesen Anwendungen verhilft die erfindungsgemäße Anordnung des Diodenarrays 20 in dem Erfassungsfenster 15 zu einer effektiveren Steuerung der Ausrichtung des Lichtstrahls relativ zu dem Erfassungsfenster. Als Daten erfassende Diode 25 muß einfachstenfalls lediglich eine einzige vorgesehen sein, weshalb lediglich eine entsprechende Datenausleseschaltung 35 erforderlich ist, die auf die Datenrate der zu empfangenden Daten ausgelegt ist. Die Auslese der langsamereren Erfassungsdioden 21a-24d kann, wie oben beschrieben, in eine serielle Ausgabe an einem Ausgang 45 münden, so daß lediglich ein Pin bei Implementierung in einem Chip erforderlich ist.

Bezugnehmend auf Fig. 1 wird abschließend noch darauf hingewiesen, daß das in Fig. 1 gezeigte Ausführungsbeispiel lediglich exemplarischer Natur ist. Die Anzahl von Erfassungsdioden 21a-24d des Diodenarrays 20 kann variieren und beispielsweise an die zur Verfügung stehenden Aktuatoren, die auf die Fehlausrichtung Einfluß nehmen können, d.h. an den Grad der Genauigkeit bei der Entgegenwirkung gegen Fehlausrichtungen, angepaßt werden. In dem Fall, daß eine Fehlausrichtung des Lichtstrahls beispielsweise lediglich entlang einer Richtung bzw. Dimension zu erwarten und deshalb nur ein Aktuator zur Entgegenwirkung einer Fehlausrichtung entlang dieser Richtung vorgesehen ist, kann beispielsweise ein 2x1-Array von Erfassungsdioden ausreichend sein. Umgekehrt können auf der Datenerfassungsseite verschiedene Anwendungen, wie z.B. in dem Fall paralleler Übertragungsstrecken, bei denen ein Diodenarray als Empfänger einem Sender eines Lichtstrahlenbündels gegenübersteht, das Vorsehen von mehr als einer zur Datenerfassung verwendeter Erfassungsdiode 25 erforderlich machen. Folglich könnte neben dem Array 20 ein Array von Erfassungsdioden 25 vorgesehen sein, wie es bei dem bezugnehmend auf die nachfolgenden Figuren beschriebenen Ausführungsbeispiel der Fall ist. Ein solches doppeltes HF- und LF-Dioden-Array könnte in optischen Empfängern in optischen parallelen Übertragungsstrecken zum Datenempfang mit gleichzeitiger Strahlausrichtungsfahlausrichtungkompensation eingesetzt werden, beispielsweise wie in "Integrated optical receiver with beam localisation" von Linten at al. in Electronics letters, Bd. 38, Nr. 10, beschrieben, welche Beschreibung hiermit unter Bezugnahme aufgenommen wird.

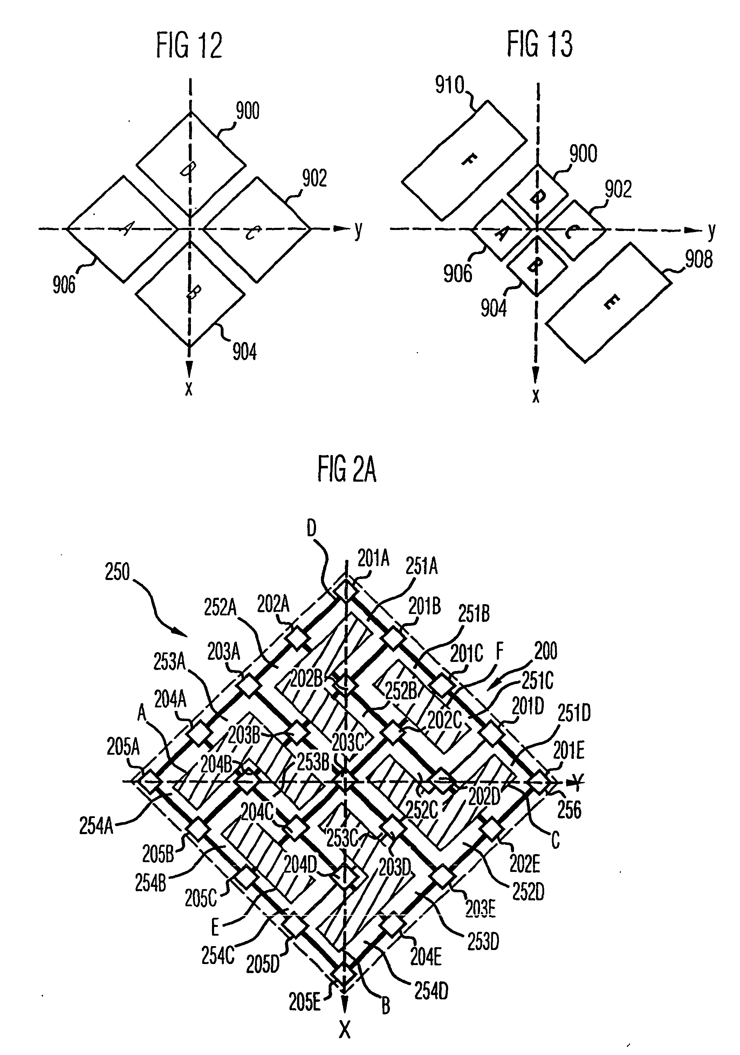

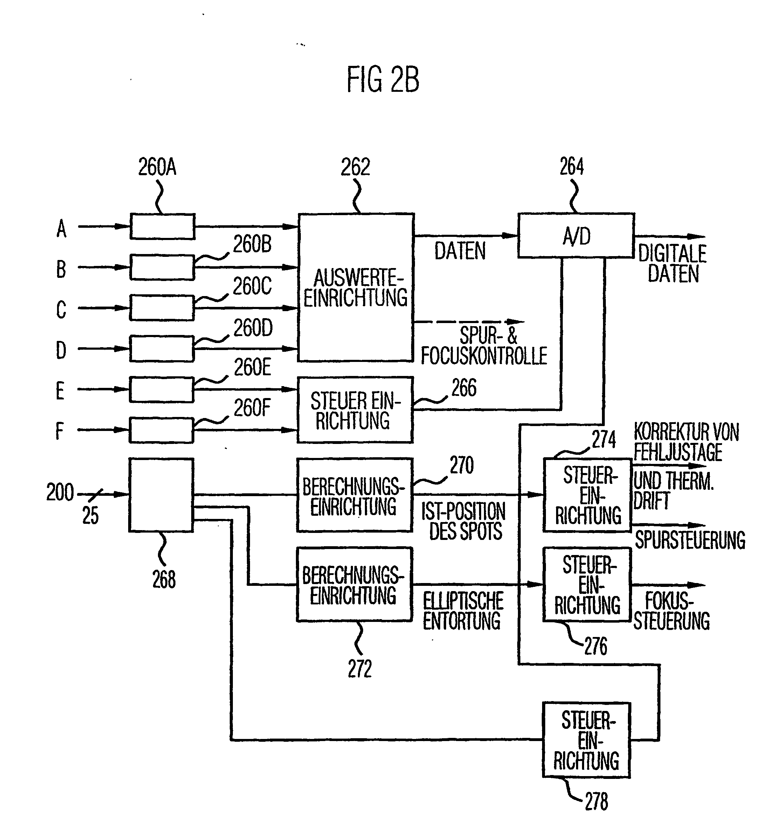

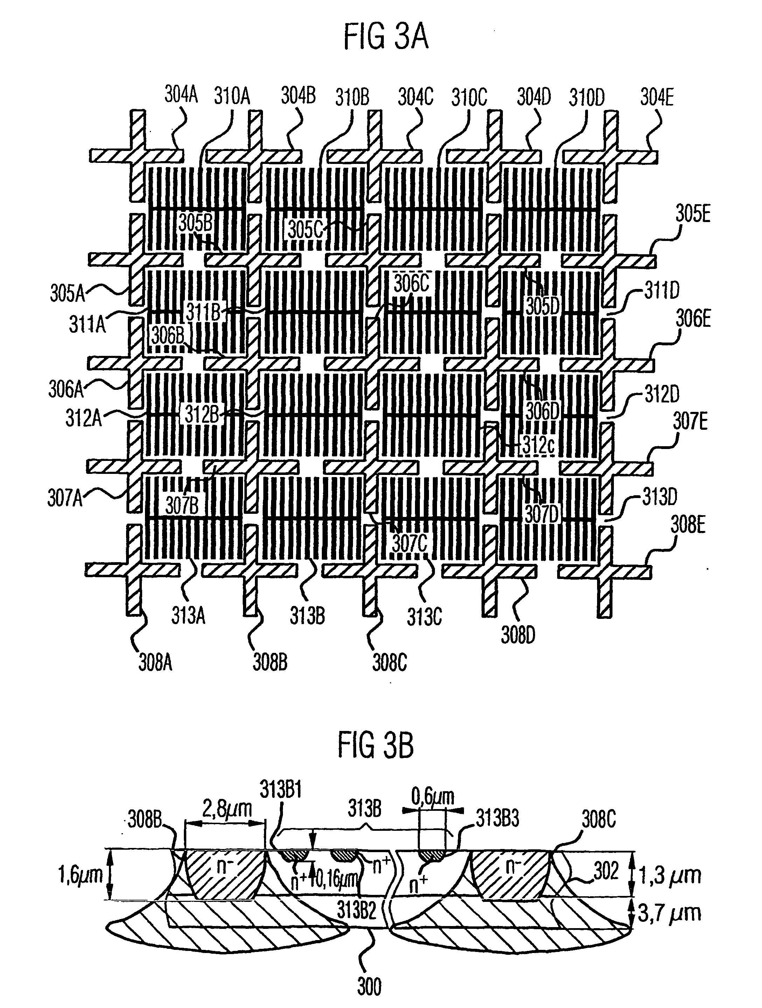

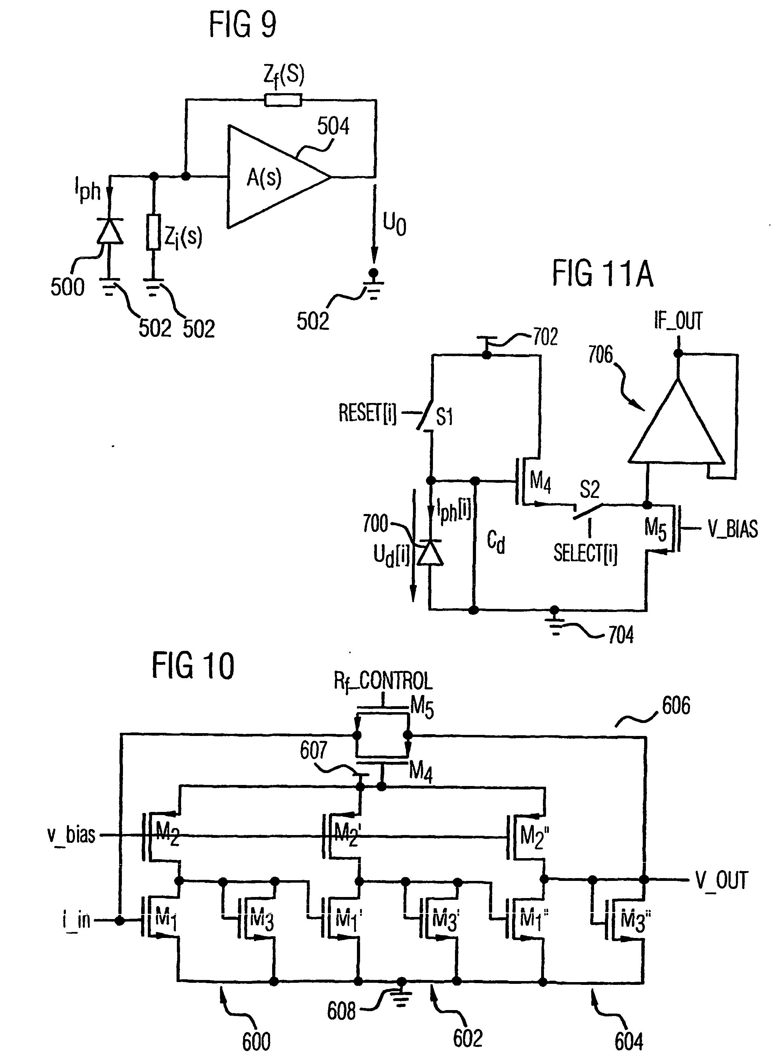

Im folgenden wird nun bezugnehmend auf die Fig. 2-11 ein Ausführungsbeispiel einer optische Abtastvorrichtung beschrieben, die dazu geeignet ist, in herkömmliche CD- und DVD-Geräte implementiert zu werden, und dabei aber zusätzliche Möglichkeiten in Hinblick auf Fokus- und Spurregelung und weitere eine Fehlausrichtung des zu erfassenden Lichtstrahls von dem Erfassungsfenster der Optikerfassungsvorrichtung verhindernde Maßnahmen ermöglicht. Obwohl die Diodenanordnung der optischen Abtastvorrichtung, die im folgenden bezugnehmend auf Fig. 2a beschrieben werden wird, auch für andere Anwendungen geeignet ist, wird sie im folgenden einer besseren Verständlichkeit halber lediglich im Rahmen ihres Einbaus in die optische Abtastvorrichtung vor dem Hintergrund der Anwendung bei CD-Geräten beschrieben. Während Fig. 2a schematisch die Diodenanordnung zeigt, zeigt Fig. 2b den Auslese- und Regelungsteil der optischen Abtastvorrichtung. Die Fig. 3a, 3b und 4 bis 8 zeigen ein Ausführungsbeispiel für eine Realisierung der Diodenanordnung in CMOS-Technologie bzw. ihre Eigenschaften, wobei Fig. 9 bis 11 Ausführungsbeispiele für mögliche Auswerteschaltungen zur Auslese der Dioden der Diodenanordnung zeigen.

Die optische Abtastvorrichtung, die im folgenden bezugnehmend auf Fig. 2-11 beschrieben wird, ist in ein

EP 1 516 164 B1

CD-Laufwerk eingebaut, welches nicht gezeigt ist und dessen Aufbau grundsätzlich bekannt ist. Die im folgenden beschrieben optische Abtastvorrichtung stellt lediglich den Erfassungs- und Auslese- und Steuersignalerzeugungsteil des CD-Laufwerkes dar. Daneben umfaßt das CD-Laufwerk einen Antrieb zum Rotieren einer als optische Platte in das Laufwerk eingelegten CD, eine Laserdiode als Lichterzeugungseinrichtung, die einen Lichtstrahl erzeugt, eine Optik und Aktuatoren als Servoeinrichtung zum Einstellen eines Abstandes des Trägers zur Spur und einer lateralen Lage des Trägers relativ zur Spur abhängig von Steuersignalen zur Spur- und Fokussteuerung, wie sie wie im folgenden beschrieben aus der durch die Diodenanordnung erfaßten Intensitätsverteilung des Lichtstrahls ermittelt werden. Die Optik besteht aus optischen Bauelementen, wie z.B. einen Kollimator zum Kollimieren des Laserstrahls, einen polarisationsabhängig durchlässig oder ablenkenden Srahlteiler, ein polarisationsrichtungsveränderndes 45°-Plättchen, eine Objektiv- bzw. Sammellinse zum Bündeln des kollimierten Laserstrahls auf die auszulesende Spur der CD, auf der die auszulesenden Daten gespeichert sind, und eine Astigmatischen Linse zum Abbilden des von der Spur reflektierten und die Objektivlinse aufgefangenen Lichtstrahls auf das Diodenarray. Diodenanordnung, Laserdiode und Optik sind gemeinsam auf dem Lesekopf angebracht und weisen folglich eine fest Lage zueinander auf, die derart ausgelegt ist, daß der von der Spur modulierte und reflektierte Lichtstrahl über die Optik derart zu der Diodenanordnung geleitet wird, daß bei optimalen Betrieb der Lichtstrahl auf dem Diodenarray von Fig. 2a an einer Soll-Position angeordnet, z. B. zentriert, ist. Mehrere widrige Umstände können dafür verantwortlich sein, daß die Ist-Position die der reflektierte Laserstrahl auf dem Diodenarray von Fig. 2a einnimmt von der Soll-Position abweicht, wie z.B. eine Fehljustierung, eine thermische Drift, eine laterale oder strahlrichtungsmäßige Fehlausrichtung des Lesekopfes, wobei dieser Abweichung durch den Auslese- und Steuerungsteil von Fig. 2b durch Erzeugung geeigneter Steuersignale für die Servoeinrichtung aus der erfaßten Intensität durch die Diodenanordnung von Fig. 2a entgegengewirkt wird, wie es im folgenden näher erörtert werden wird.

Fig. 2a zeigt schematisch die Diodenanordnung der optischen Abtastvorrichtung, die zur Erfassung einer Intensitätsverteilung eines Lichtstrahls in einem Erfassungsfenster und zum Erfassen von durch den Lichtstrahl übertragenen Daten vorgesehen ist und somit den Erfassungsteil der optischen Abtastvorrichtung darstellt. Insbesondere umfaßt die Diodenanordnung von Fig. 2a ein 5x5-Array 200 von Erfassungsdioden 210a-201e, 202a-202e, 203a-203e, 204a-204e und 205a-205e, wobei die letzte Ziffer eine Zeilennummer und der Buchstabe eine Spaltennummer des 5x5-Arrays angibt. Ferner umfaßt die Diodenanordnung von Fig. 2a ein 4x4-Array 250 von Erfassungsdioden 251a-251d, 252a-252d, 253a-253d, 254a-254d. Die beiden Arrays 200 und 250 sind derart zueinander angeordnet, daß sich die Erfassungsdioden 251a-254d jeweils in den Zwischenräumen zwischen den Erfassungsdioden 201a-205e befinden. Anders ausgedrückt, sind die Erfassungsdioden 251a-254d flächenzentriert zu den Erfassungsdioden 201a-205e angeordnet und bilden zusammen eine zweidimensionale kubisch raumzentrierte Anordnung. Alle Erfassungsdioden 201a-205e und 251a-254d sind gemeinsam in demselben Erfassungsfenster 256 angeordnet, das zur Erfassung des Lichtstrahls vorgesehen ist, der von der auszulesenden Spur zurückreflektiert und von den Pits der Spur moduliert wird, so daß er die auszulesenden Daten umfaßt. Die 25 Erfassungsdioden 201a-205e sind jeweils einzeln mit einer Ausleseschaltung 268 (Fig. 2b) verbunden, die dieselben seriell ausliest, um die Ausgangssignale derselben in gemultiplexter Form auszugeben. Die Erfassungsdioden 251a-254d des Diodenarrays 250 sind zu sechs Bereichen A, B, C, D, und F miteinander verschaltet bzw. zueinander parallel geschaltet und mit verschiedenen Ausleseschaltungen 260a, 260b, 260c, 260d, 260e und 260f (Fig. 2b) verbunden, die eine höhere Auslesegeschwindigkeit als die Auslesegeschwindigkeit aufweisen, die zur Auslese der Erfassungsdioden 201a-205e des 5x5-Arrays 200 verwendet wird. Insbesondere sind, wie in Fig. 2 angedeutet, die Erfassungsdioden 254a, 253a und 253b zu dem Bereich A, die Erfassungsdioden 254d, 253d, und 253c zu dem Bereich B, die Erfassungsdioden 252d, 251d und 252c zu dem Bereich C, die Erfassungsdioden 251a, 252a und 252b zu dem Bereich D, die Erfassungsdioden 254b und 254c zu dem Bereich E und die Erfassungsdioden 251b und 251c zu dem Bereich F zusammengefaßt.

Im folgenden werden die Erfassungsdioden 201a-205e mit geringerer Auslesegeschwindigkeit als LF-Dioden bezeichnet, während die Erfassungsdioden 251a-254d mit höherer Auslesegeschwindigkeit als HF-Dioden bezeichnet werden. Die seriell ausgelesenen LF-Dioden 201a-205e werden zur Generierung von Steuersignalen für die Fokus- und Spursteuerung und für die Ansteuerung von Aktuatoren des CD-Gerätes (nicht gezeigt) verwendet, in welches die optische Abtastvorrichtung mit dem Diodenarray von Fig. 2a eingebaut ist. Die HF-Dioden 251a-254d dienen der Erfassung der durch den auf die Diodenanordnung von Fig. 2a einfallenden Lichtstrahl übertragenen Daten. Die Untergliederung derselben in die Bereiche A-F bietet, wie im folgenden beschrieben, die Möglichkeit, daß die in Fig. 2a gezeigte Diodenanordnung Signale A-D liefert, wie sie auch in herkömmlichen CD-Geräten zur Spur- und Fokusregelung verwendet werden, die für ein Fokus- und Servosignalerzeugung basierend auf einer Diodenanordnung gemäß Fig. 12 konzipiert sind. Die Bereiche E und F sind derart angeordnet, daß sie, wie es im folgenden erläutert werden wird, zur Erfassung von Crosstalkerscheinungen eingesetzt werden können.

Nachdem im vorhergehenden der Aufbau der Diodenanordnung von Fig. 2a beschrieben worden ist, wird im folgenden der Teil der optischen Abtastvorrichtung beschrieben, der für die Auslese der Dioden und die Servosignalerzeugung zuständig ist. Die in den Bereichen A-F erzeugten Ströme werden, wie oben erwähnt, jeweils durch eine Ausleseschaltung 260a, 260b, 260c, 260d, 260e und 260f ausgelesen bzw. verstärkt, wobei dieselben beispielsweise als Transimpedanzverstärker ausgebildet sind, für die ein Ausführungsbeispiel bezugnehmend auf Fig. 9 und 10 näher beschrieben wird. Die Ausgänge der Ausleseschaltungen 260a-260d sind mit einer Auswerteschaltung 262 verbunden, die an einem Ausgang ein Datensignal an einen A/D-Wandler 264 ausgibt, an dessen Ausgang wiederum die durch den Lichtstrahl übertragenen Daten in digitaler Form ausgegeben werden. Die Auswerteschaltung 262 kann ferner ausgebildet sein, um die Eingangssignale der HF-Diodenbereiche A, B, C und D wie herkömmlich dazu zu nutzen, Steuersignale zur Spur- und Fokuskontrolle zu erzeugen und an einem oder mehreren weiteren Ausgängen auszugeben, wie es durch die gestrichelte Linie dargestellt ist. Beispielsweise ist die Auswerteeinrichtung 262 in einen entsprechenden Modus versetzbar, bei der sie zusammen mit dem Diodenarray von Fig. 2a wie eine herkömmliche Optikerfassungseinrichtung nach Fig. 12 verwendet werden kann. Die Ausgänge der Ausleseschaltungen 260e und 260f sind mit einer Steuereinrichtung 266 verbunden, der an einem Ausgang ein Crosstalkdetect-Signal an einen Steuereingang des A/D-Wandlers 264 ausgibt.

Die Stromausgangssignale der Erfassungsdioden 201a-205e des Diodenarrays 200 werden, wie oben erwähnt, einer Ausleseschaltung 268 zugeführt, die dieselben seriell an zwei Berechnungseinrichtungen 270 und 272 ausgibt, wobei ein Ausführungsbeispiel für den Aufbau der Ausleseschaltung 268 bezugnehmend auf Fig. 11a näher erörtert werden wird. Die Berechnungseinrichtung 270 berechnet die Ist-Position des Spots auf der Diodenanordnung von Fig. 2. Die Berechnungseinrichtung 272 berechnet die elliptische Entartung, d.h. das Ausmaß und die Richtung derselben, des Spots auf der Diodenanordnung von Fig. 2. Die berechneten Informationen der Berechnungseinrichtung 270 werden einer Steuereinrichtung 274 zugeführt, die abhängig von denselben Steuersignale zur Korrektur von Fehljustage und thermischer Drift und zur Spursteuerung an geeignete Aktuatoren ausgibt, die die Lage des Lesekopfes quer zur Spur und die laterale Position der Diodenanordnung von Fig. 2a verändern, wie es im folgenden näher erörtert werden wird. Die Informationen der Berechnungseinrichtung 272 werden an eine Steuereinrichtung 276 ausgegeben, die abhängig von denselben Steuersignale zur Fokussteuerung an einen entsprechenden Aktuator zur Veränderung des Abstandes zur optischen Platte erzeugt. Eine Steuereinrichtung 278 empfängt das Auslesesignal der Ausleseschaltung 268 direkt und ermittelt aus demselben ein Steuersignal zur Kompensation von Diskverkippungen und Substratdickevariationen, wie es im folgenden erörtert wird, um es an einen weiteren Steuereingang des A/D-Wandlers auszugeben.

Im folgenden wird die Funktionsweise der optischen Abtastvorrichtung mit der Diodenanordnung von Fg. 2a und dem Auslese- und Steuerteil von Fig. 2b und ihre vorteilhafte Anwendung und Funktionsweise vor dem Hintergrund des CD-Laufwerkes beschrieben, in welches dieselbe eingebaut ist.

Zur Datenauslese werden die Signale der HF-Dioden der Bereiche A, B, C und D durch die Auswerteeinrichtung 262 zusammengefaßt, d.h. ihre Ausgangssignale addiert. Der A/D-Wandler digitalisiert das zusammengefaßte Ausgangssignal der Bereiche A-D basierend auf einem Schwellenwert, das derselbe aus dem Signal crosstalkdetect von der Steuereinrichtung 266 erhält, und gibt die digitalisierten Daten als die auszulesenden, in der auszulesenden Spur gespeicherten Daten aus. Wie in der Beschreibungseinleitung erwähnt, ist es zudem möglich, die Ausgangssignale der Bereiche bzw. Regionen A-D wie herkömmlich miteinander zu verschalten, um Steuersignale für die Fokus- und Spursteuerung zu erzeugen. Unter Verwendung einer astigmatischen Linse zur Abbildung des reflektierten, Daten übertragenden Lichtstrahls auf die Diodenanordnung von Fig. 2a ist die Auswerteeinrichtung 262 in der Lage, Signale für die Abstands- bzw. Fokusregelung zu erzeugen, indem dieselbe die Ausgangssignale der Bereiche A, B, C und D von den Ausleseschaltungen 260a-d zusammenaddiert und die Summen voneinander abzieht, d.h. (A+C) - (B+D) bildet, um die elliptische Verformung bei Defokussierung zu erfassen, wobei angenommen wird, daß die Hauptachsen der astigmatischen Linse entlang der in Fig. 2a angezeigten Achsen x und y verlaufen. Ein Aktuator verstellt dann gemäß dem Fokusregelungssignal den Abstand der Objektivlinse zur optischen Platte. Ferner ist die Auswerteschaltung 262 in der Lage, Signale zur Spurregelung, d.h. zur Steuerung der radialen Bewegung des Lesekopfes über die sich drehende optische Platte, zu erzeugen, indem sie das Signal (A+D) - (C+B) auswertet, das für das sogenannte Pushpull-Muster charakteristisch ist, das durch Interferenz von Brechungsordnungen bewirkt wird, die durch die Erhöhungen erzeugt werden, die wie ein Phasengitter wirken.

Neben den Signalen der Bereiche A, B, C, D, die auch mittels des in Fig. 12 dargestellten Diodenarrays erzeugt werden, stellen nun die Bereiche E und F weitere Signale bereit. In dem vorliegenden Fall sind diese Bereiche derart angeordnet, daß sie an Stellen angeordnet sind, an denen mit Crosstalkerscheinungen aufgrund der gleichzeitigen Auslese zweier Spuren zu rechnen ist, d.h. dadurch, daß der auf die optische Platte fokussierte Auslesespot sowohl die eigentlich auszulesende als auch eine benachbarte Spur mit seinen äußeren Rändern beleuchtet. Bei einer herkömmlichen Diodenanordnung wie in Fig. 12 würde ein solches Crosstalkphänomen zur Stimulierung der Bereiche A und B auf der einen und C und D auf der anderen Seite (siehe Fig. 12) führen, wodurch es bei der Verrechnung von A + B + C + D zur Datenrückgewinnung zu einem Bitfehler kommen könnte, wenn auf der benachbarten Spur ein anderer binärer Wert (Pit oder Nicht-Pit) vorliegt als auf der tatsächlichen Spur. Durch Vorsehen der beiden zusätzlichen Bereiche E und F kann eine solche Stimulierung durch eine Crosstalkerscheinung erfaßt werden. Hierzu empfängt die Steuereinrichtung 266 die Auslesesignale von den Ausleseschaltungen 260e und 360f und erfaßt, ob das Ausgangssignal eines der beiden Bereiche E und F einen Schwellenwert überschreitet. Ist dies der Fall, stellt die Steuereinrichtung 266 die Entscheidungsschwelle für die Digitalisierung des Signals A + B + C + D durch den A/D-Wandler 264 durch das Signal crosstalkdetect entsprechend höher ein, um einen Bitfehler zu verhindern, da die Crosstalkerscheinung in dem Summensignal zu einem fälschlichen zu hohem Intensitätswert führen kann.

Während im vorhergehenden die Zusammenfassung der HF-Dioden 251a-254d zu Bereichen A-F sowie die Verwendung dieser zusammengefaßten Signale bei der Auslese einer Spur einer CD beschrieben wurde, wird im folgenden die Verwendung der Ausgangssignale der LF-Dioden 201a-205e beschrieben, wobei wiederum angenommen wird, daß der auf die Spur der CD fokussierte Spot durch eine astigmatische Linse mit den Hauptachsen X und Y auf die Diodenanordnung von Fig. 2 abgebildet wird, so daß ein zu geringer Abstand der Objektivlinse der Optik, die den Laserstrahl von der Laserdiode auf die CD fokussiert und den reflektierten Lichtstrahl zusammen mit der astigmatischen Linse auf die Diodenanordnung von Fig. 2 abbildet, zu der CD zu beispielsweise einer elliptischen Entartung entlang der Achse y und eine zu große Entfernung zu einer elliptischen Entartung entlang der Achse x führt.

Die Verwertung der durch die LF-Dioden 201a und 205e erfaßten Intensitätsverteilung des Lichtstrahls findet durch die Berechnungseinrichtungen 270, 272 und die Steuereinrichtungen 274, 276 statt. Die Berechnungseinrichtung 270 berechnet aus dem Auslesesignal der Ausleseschaltung 268, das die Intensitätsverteilung des erfaßten Lichtstrahls an dem LF-Diodenarray darstellt, eine Lage des Intensitätsschwerpunktes bzw. eine Ist-Position des Lichtstrahls auf der Diodenanordnung von Fig. 2a und gibt diese Informationen an die Steuereinrichtung 274 aus, während die Berechnungseinrichtung 272 aus denselben Informationen eine Form bzw. eine elliptische Entartung des Laserspots bestimmt und an die Steuereinrichtung 276 ausgibt. Die Bestimmungen durch die Berechnungseinrichtungen 270 und 272 können beispielsweise mittels Interpolation oder Fits bzw. Anpassungsfunktionsbestimmung über die Intensitätswerte der LF-Dioden und anschließende Auswertung, wie z.B. Extremalstellensuche im Fall der Ist-Positionsbestimmung und Analyse der Ausdehnung einer Linie gleicher Intensität im Fall der Entartungsbestimmung, ermittelt werden.

Mittels der Lageinformationen des Spots auf der Diodenanordnung von Fig. 2a erzeugt die Steuereinrichtung 274 Steuer- bzw. Servosignale zur Kompensation von Fehljustierungen innerhalb des Lesekopfes, d.h. zwischen Laserdiode, Optik und/oder Diodenanordnung, sowie thermische Driften zwischen denselben, und Steuer- bzw. Servosignale zur Spursteuerung. Die Steuereinrichtung 274 steuert beispielsweise abhängig von einer Abweichung der durch die Einrichtung 270 berechnete Ist-Position des Laserspots auf der Diodenanordnung von Fig. 2a von einer Soll-Position, die vorliegend in dem Schnittpunkt der beiden Achsen X und Y liegt, geeignete Aktuatoren, wie z.B. Piezoelemente, an, um die Diodenanordnung entsprechend lateral zu verschieben, oder andere Aktuatoren, die die relative Position des Lesekopfes quer zur auszulesenden Spur verstellen. Die Möglichkeit der lateralen Einstellung des Diodenanordnung lockert die Anforderungen an den Fertigungsprozeß eines Lesekopfes, indem die Optikerfassungsvorrichtung sowie die dazugehörige Optik und die Laserdiode eingebaut sind, und bewirkt somit eine Kostenersparnis in der Herstellung des Lesekopfes bzw. des CD-Gerätes. Hierbei sei darauf hingewiesen, daß die Matrix von LF-Dioden 200 zu diesem Zweck auch über das Gebiet der HF-Diodenmatrix 250 erweitert sein könnte, so daß ein größeres Gebiet zur elektronischen Justage entstehen würde.

Ebenso wie Fehljustierungen und thermische Driften führen, wie soeben erwähnt, auch Fehlausrichtungen des Lesekopfes quer zur auszulesenden Spur zu einer Verschiebung der Ist-Position des durch den zu erfassenden Lichtstrahl auf der Diodenanordnung von Fig. 2a erzeugten Spots. Mit dem LF-Diodenarray 200 von Fig. 2a bzw. der dadurch erfaßbaren Ist-Position des Spots ist jedoch eine Überwachung des Verlaufs dieser Ist-Position quantitativ ausrechend genau möglich, um wiederum eine vorausschauende Steuerung bzw. Servosignalerzeugung zur Spurkorrektur zu ermöglichen. Die Steuereinrichtung 276 könnte beispielsweise den für die radiale Versetzung des Lesekopfes bzw. die Verschiebung in Richtung quer zur Spur zuständige Aktuator um so stärker angesteuert werden, je mehr die Ist-Position des Spots von der Sollposition abweicht, und vorausschauend noch stärker, je schneller die Zunahme der Abweichung ist.

Diskverkippungen der optischen Platte aus einer Sollebene und Substratdickevariationen auf dem Speichermedium bzw. der optischen Platte führen zu unterschiedlichen Reflektivitäten. Der Mittelwert der durch die LF-Dioden 201a-205e erfaßten Lichtintensitäten wird deshalb durch die Steuereinrichtung 278 dafür verwendet, diese unterschiedlichen Reflektivitätsverhältnisse bei der Datenrückgewinnung dadurch zu berücksichtigen, daß die Entscheidungsschwelle für die Digitalisierung des Signals A + B + C + D bei der Digitalisierung durch den A/D-Wandler im Fall verringerter Reflektivität niedriger und andernfalls höher eingestellt wird. Dies lockert ebenfalls die Anforderungen an den Fertigungsprozeß des CD-Gerätes sowie bei der Herstellung der optischen Platten selbst und resultiert somit in einer Kostenersparnis.

Wie erwähnt führen Fokusfehler zu einer elliptischen Entartung des Laserspots auf der Erfassungsdiodenanordnung von Fig. 2. Die elliptische Entartung ist mittels der LF-Dioden 201a-205e erfaßbar und wird durch die Bestimmungseinrichtung 272 bestimmt, so daß die Steuereinrichtung 276 abhängig von der erfaßten elliptischen Entartung bzw. der Ausrichtung derselben und dem Ausmaß derselben ein Steuersignal zur Fokussteuerung bzw. ein Steuersignal an einen Aktuator zur Veränderung des Abstandes einer Objektivlinse von der CD einstellen kann.

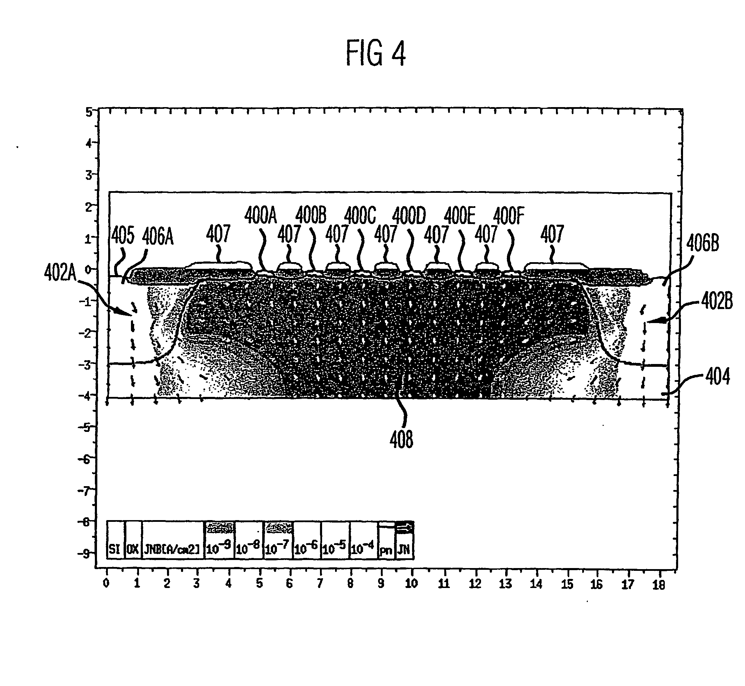

Nachdem im vorhergehenden bezugnehmend auf die folgenden Figuren wird eine vorteilhafte Realisierung einer Diodenanordnung von Fig. 2a beschrieben, die in CMOS-Technologie, wie z.B. einer 0,6 µm-Standard-CMOS-Technologie, implementierbar ist. Zunächst wird bezugnehmend auf Fig. 3a und 3b das Layout der Diodenanordnung beschrieben. Fig. 3a zeigt eine Draufsicht auf die Diodenanordnung, während Fig. 3b ein Schnittbild entlang der in Fig. 3a mit der gestrichelten Linie angezeigte Schnittebene darstellt. Die gesamte Diodenanordnung ist auf einem epitaktischen p$^-$-dotiertem Silizium- (Si-) Substrat 300 gebildet. Eine p$^-$-Wanne 302 erstreckt sich über das gesamte Gebiet, das durch die Diodenanordnung eingenommen wird, und ist in Fig. 3a nicht dargestellt. Die LF-Dioden sind mittels in Form eines Kreuzes strukturierter n$^-$-Wannen in der p$^-$-Wanne hergestellt worden, und sind mit dem Bezugszeichen 304a-308e versehen. Die n$^-$-Wannen 304a-308e erstrecken sich, wie es in Fig. 3b zu sehen ist, entlang des Querschnittes bis hinab in das epitaktische p$^-$-Substrat 300. Die HF-Dioden sind durch Doppelkamm-strukturierte, quadratische n$^+$-Diffusionsbereiche in der p$^-$-Wanne 302 gebildet und mit dem Bezugszeichen 310a-313d versehen. In Fig. 3b ist lediglich der Schnitt durch den n$^+$-Diffusionsbereich 313b gezeigt, wobei insbesondere lediglich drei Finger 313b1, 313b2 und 313b3 der Doppelkammstruktur gezeigt sind. Die kreuzstrukturierten n$^-$-Wannen 304a-308e erstrecken sich mit ihren vier Armen jeweils zwischen zwei benachbarte n$^+$-Diffusionsbereiche 310a-310d, derart, daß jedes Paar benachbarter n$^+$-Diffusionsbereiche durch zwei sich aufeinander zu streckende und über eine Lücke beabstandete Arme benachbarter n$^-$-Wannen im wesentlichen getrennt ist. Die Kontaktierungen der n-Elektroden der einzelnen LF- und HF-Dioden kann durch geeignetes Führen von Leiterbahnen vorgesehen sein. Wie es Fig. 3b zu entnehmen ist, betragen exemplarische Abmessungen für das Layout: 1,6 µm Tiefe der n$^-$-Wannen, 2,8 µm Breite der vier Arme der n$^-$-Wannen, 0,16 µm Tiefe und 0,6 µm Breite der Finger der n$^+$-Diffusionsbereiche, 3,7µm Dicke des epitaktischen Si-Substrates 300 und 1,3 µm Dicke der 1,3µm Tiefe der p$^-$-Wanne 302. Die Vorzüge, die sich aus den lateralen Formen, den Querschnitten und den Dotierungen der LF- und HF-Dioden ergeben, die durch die n$^-$-Wannen 304a-308e bzw. die n$^+$-Diffusionsbereiche 310a-313d in der p$^-$-Wanne 302 gebildet werden, werden im folgenden bezugnehmend auf die Fig. 4 bis 8 näher erläutert.

Ein Vorteil der kammartigen Struktur der n$^+$-Diffusionsbereiche der HF-Dioden besteht darin, daß die Eindringtiefe für Wellenlängen in Silizium in dem nahen ultravioletten Bereich, d.h. 405 nm, die für zukünftige Generationen von Speichersystem relevant sein werden, etwa 200 nm beträgt, so daß die Elektronenlochpaare hauptsächlich an der Oberfläche erzeugt werden. Dies bedeutet, daß die Elektronenlochpaare wirksamer durch laterale pn-Übergänge, d.h. diejenigen Abschnitte der pn-Übergänge, bei denen sich die pn-Grenzfläche von der Oberfläche weg im wesentlichen senkrecht zur Oberfläche erstreckt, getrennt werden, wie sie entlang des Umfangs der n$^+$-Diffusionsbereiche und der in n$^-$-Wannen vorkommen. Da durch die Kammstruktur der n$^+$-Diffusionsbereiche 310a-313d das Verhältnis der Länge des Umfangs zur lateralen Fläche der n$^+$-Diffusionsbereiche 310a-313d besonders groß ist, führt dies zu einer verbesserten Empfindlichkeit bzw. Antwort der n$^+$-Diffusionsbereiche 310a-313d bzw. der streifenförmigen Diodenfinger 313b1-313b3 in diesem Wellenlängenbereich gegenüber kompakteren Strukturen.

Ein weiterer Vorteil der kammartigen Struktur der n$^+$-Diffusionsbereiche 310a-313d besteht darin, daß dieselben eine geringe Photodiodenkapazität aufweisen. Dies ist vorteilhaft, da dieselben eine möglichst schnelle Auslese ermöglichen sollen, und da dies bei der Auslese mittels Transimpedanzverstärkern, wie sie bezugnehmend auf Fig. 9 und 10 beschrieben werden wird, zu einer erhöhten Bandbreite bei der Auslese führt. So hängt in dem Fall der Verwendung eines Transimpedanzverstärker mit einer hohen Bandbreite von beispielsweise bis zu 250 MHz und einer hohen Transimpedanz von beispielsweise bis zu 200 kΩ zur Auslese die Bandbreite $f_{-3dB}$ des Auslesesystems aus Transimpedanzverstärker und Diode beispielsweise folgendermaßen von der Photodiodenkapazität $C_{Diode}$ ab:

$$f_{-3dB} \propto \frac{A}{2\pi R_f} \cdot \frac{1}{C_{Diode}}$$

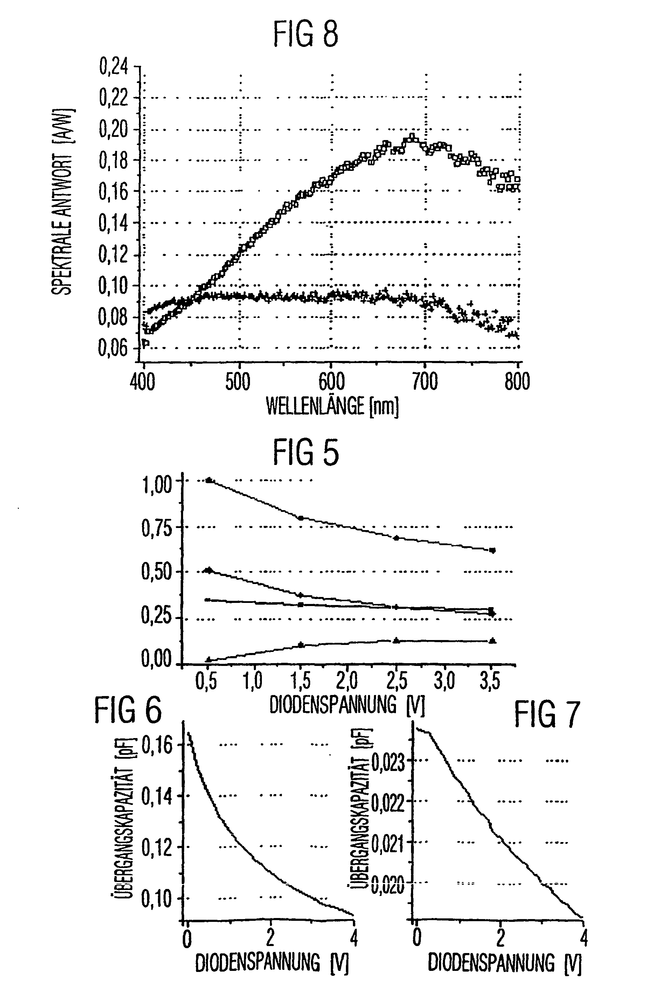

wobei $R_f$ die Transimpedanz und A die Gleichsignalverstärkung des Transimpedanzverstärkers und $C_{Diode}$ die Photodiodenkapazität darstellt. Zur Erzielung hoher Bandbreiten, wie es für die für die Datenrückgewinnung zuständigen HF-Dioden wünschenswert ist, ist es folglich notwendig, die Grenzflächenkapazität der auszulesenden Diode so niedrig wie möglich zu halten, um die Anforderungen zu minimieren, die dem Transimpedanzverstärker aufgebürdet werden. Daß die Doppelkammstruktur der n$^+$-Diffusionsbereichen 310a-313d der HF-Dioden zu einer Verringerung der Photodiodenkapazität führt, zeigt Fig. 5. In Fig. 5 ist die Flächenkapazität der HF-Dioden in Einheiten pro Flächeneinheit (angezeigt mit runden Punkten) und die Umfangs- bzw. Seitenwandkapazität derselben in Einheiten pro Längeneinheit (angezeigt mit Vierecken) gegen die Diodenspannung V über die HF-Dioden aufgetragen. Wie es zu sehen ist, verhilft die Kammstruktur den HF-Dioden zu einer kleineren Diodenkapazität aufgrund des höheren Umfang/Fläche-Verhältnisses, so daß die erzielbare Bandbreite des Auslesesystems, welches bezugnehmend auf Fig. 9 und 10 näher beschrieben werden wird, entsprechend höher ist.

Die Vorzüge der Wannen-Struktur der LF-Dioden bestehen hauptsächlich darin, daß diese Struktur zu einer größeren vertikalen (Tiefen-) Ausdehnung der Wanne verglichen zu derjenigen der n$^+$-Diffusionsbereiche führt. Zusätzlich sorgt die laterale Form der n$^-$-Wannen 304a-308e als Kreuze dafür, daß jede HF-Diode beinahe vollständig durch die Arme von vier benachbarten n$^-$-Wannen 304a-308e umgeben ist. Insgesamt wird hierdurch eine Art Schutzring für diese HF-Dioden sowohl in lateraler als auch, durch den tiefen Querschnitt der n⁻-Wannen, in vertikaler Richtung gebildet wird. Denn falls Ladungen entlang des Umfanges einer HF-Diode erzeugt werden, werden dieselben eher durch eine LF-Diode 304a-308e eingefangen als durch eine benachbarte HF-Diode, was folglich eine Übersprech-Trennung in lateraler Richtung zwischen den HF-Dioden ergibt. Diffundierende Ladungsträger in der Epitaxieschicht 300, die nicht durch die HF-Diode aufgefangen wurden, werden durch eine der benachbarten LF-Dioden eingefangen, so daß dieselben nicht zu einer anderen, benachbarten HF-Diode diffundieren können, was für die vorliegende Anmeldung als eine vertikale Übersprech-Trennung der HF-Dioden bezeichnet wird. Dies führt zu einer erhöhten Auflösung der durch die HF-Dioden erfaßten räumlichen Intensitätsverteilung.

Ein weiterer Vorteil des oben beschrieben "Absaugens" diffundierender Ladungsträger durch die LF-Dioden besteht darin, daß diese diffundierenden Ladungsträger aufgrund ihrer Diffusionszeit die Pulsform der Diodenantwort verschmieren würden, und somit zu einer langsameren Datenauslesegeschwindigkeit führen würden. Da das Auslesen der LF-Dioden, wie es im folgenden bezugnehmend auf Fig. 11a näher erörtert werden wird und bereits im vorhergehenden kurz erwähnt wurde, bei niedrigeren Frequenzen im Bereich von kHz ausgeführt wird, hat der langsame Diffusionsstrom, der durch die LF-Dioden eingefangen wird, umgekehrt jedoch keine Auswirkung auf die Erfassung der Intensitätsverteilung des einfallenden Lichtstrahles durch die LF-Dioden, die, wie oben beschrieben, zur Steuerung der Ausrichtung des zu erfassenden Lichtstrahls mit dem Erfassungsfenster verwendet werden kann. Es wird ausdrücklich darauf hingewiesen, daß die "Absaugung" diffundierender Ladungsträger durch die LF-Dioden-Wannen 304a-308e, wie sie soeben beschrieben wurde, sowohl in lateraler Hinsicht als auch in vertikaler Hinsicht zu einer Abschirmung der signaldetektierenden Raumladungszonen der HF-Dioden 310a-313d führt. Die laterale Abschirmung wurde im vorhergehenden im Rahmen der Übersprechschutzwirkung der LF-Dioden-Wannen 304a-308e beschrieben. Die vertikale Abschirmung tritt aufgrund einer Ausbauchung der durch die LF-Dioden-Wannen 304a-308e ausgebildeten Raumladungszonen auf, die in der Seitenschnittdarstellung von Fig. 3b mit 328b und 328c für die Dioden-Bereiche 308b und 308c dargestellt sind. Die mit der Tiefe zunehmende Ausbauchung der Raumladungszonen 328b und 328c ergibt sich aufgrund eines Dotierungsprofils des Substrats 300, welches eine mit einem vorbestimmten Dotierungsgradienten abnehmende Dotierungsdichte aufweist, und geht auch aus der Simulation von Fig. 4 hervor welche im folgenden beschrieben wird. Unterstützt wird die große Ausbreitung der Raumladungszonen 328b und c noch durch die schwache Dotierung der LF-Dioden-Wannen im Vergleich zu den stark dotierten HF-Dioden und durch die im Vergleich zu den HF-Diodenbereichen 310a-313d etwa zehnfach größere Tiefenausdehnung der LF-Dioden-Wannen 304a-308e.

Das Bilden der LF-Dioden durch n⁻-Wannen anstatt durch n⁺-Diffusionsbereiche ist darin vorteilhaft, daß hierdurch ein kleinerer Kapazitätswert erzielt wird. Zur Veranschaulichung dessen sind in dem Graphen von Fig. 5 ferner die Seitenwandphotodiodenkapazität (angezeigt mit Rauten) und die Flächenphotodiodenkapazität (angezeigt mit Dreiecken) für den Fall von n⁻-Wannendioden mit ansonsten gleicher lateraler Struktur wie die den in Fig. 5 gezeigten n⁺-Diffusionsbereich-Dioden-Kapazitätswerte zugrundeliegenden Diodenstrukturen gegen die Diodenspannung V aufgetragen. Wie es zu sehen ist, ist die Kapazität einer n⁻-Wannendiode im Vergleich zu einer n⁺-Diffusion-Diode niedriger. Zudem verringert darüber hinaus die Kreuzform der n⁻-Wannen 304a-308e aufgrund des höheren Umfang/Flächen-Verhältnisses die Diodenkapazität. Die durch die Wahl der Struktur der LF-Dioden erzielte Diodenkapazitätsreduktion ergibt wiederum ein niedrigeres Signal/Rausch-Verhältnis bei der LF-Diodenauslese. So gilt in dem Fall integrativer Auslese der n⁻-Wannen-LF-Dioden, wie sie im folgenden näher bezugnehmend auf Fig. 11a erläutert werden wird, und bei der die LF-Dioden durch Integration ausgelesen und der Photostrom an der intrinsischen Grenzflächenkapazität der Photodiode integriert wird, für das Signal/Rausch-Verhältnis eines solchen Auslesesystems die Formel:

$$S/R - \text{Verhältnis} = 20 \log\left(\sqrt{\frac{I_{ph}^2 T_{int}^2}{e^-(C_{Diode}U_{Th} + I_{ph}T_{int})}}\right)$$

Hierbei ist $T_{int}$ die Integrationszeit und $U_{Th}$ die Schwellenwertspannung desjenigen Transistors, der vorgesehen ist, um bei Beginn eines Integrationszyklus die LF-Diode auf ein definiertes Potential einzustellen, $I_{ph}$ der Photostrom der Diode und $C_{Diode}$ die Photodiodenkapazität. Folglich nimmt das Signal/Rausch-Verhältnis mit abnehmender Diodenkapazität zu, was ein zusätzlicher Vorteil der kreuzstrukturierten n⁻-Wannen ist.

Mit Hilfe eines Simulationsprogrammes wurde eine Simulation der Stromdichte thermisch erzeugter Minoritätsladungsträger als Anzeichen für optische bewirkte Ladungsträger entlang einer Schnittebene durchgeführt, die bis auf die Anzahl der Finger der Doppelkamm-strukturierten n⁺-Diffusionsbereiche dem Querschnitt von Fig. 3b entspricht. Das Ergebnis dieser Simulation ist in Fig. 4 gezeigt, wobei dort die Richtung und die Länge der äquidistant angeordneten Pfeile die Richtung und den Betrag des Dunkelstroms an dem jeweiligen Ort angeben, und wobei die Zahlenskalen an der linken und der unteren Seite des Bildes Längenangaben in Mikrometern sind. Der Betrag des Dunkelstromes ist ferner durch die gestrichelte Höhenlinien bzw. Schattierung verdeutlicht. In Fig. 4 sind mehrere HF-Dioden-n$^+$-Diffusionsbereiche 400a, 400b, 400c, 400d, 400e und 400f umgeben von zwei LF-Dioden-n$^-$-Wannen 402a und 402b in einer zu Simulationszwecken ohne p$^-$-Wanne versehenen epitaktischen p$^-$-Substrat 404 gezeigt. Zur Kontaktierung der n$^-$-Wannen 402a,402b sind an der Oberfläche 405 n$^+$-dotierte Wannenkontaktbereiche 406a und 406b vorgesehen. Feldoxid ist mit 407 angezeigt und befindet sich auf der Oberfläche 405. Mit durchgezogenen Linien ist zwischen den n$^+$-Bereichen 400a-400f ein sich einstellender Leitfähigkeitsübergang der HF-Dioden angezeigt. Wie es aus Fig. 4 erkennbar ist, ergibt die Simulation, daß sich die Raumladungszone fast komplett unter die HF-Diodenfinger 400a-400f ausdehnt, was die vertikale Abschirmung der letztgenannten vor diffundierenden, in tieferen Regionen generierten Ladungsträgern und damit die höher Bandbreite der HF-Dioden aufgrund des erhöhten Driftstrom- und verringerten Diffusionsstromanteils ermöglicht. Die den Dunkelstrom repräsentierenden Pfeile, die durch die Simulation an äquidistanten Positionen berechnet worden sind, dienen als Maß für den Verlauf an Ladungsträgern, die durch Licht generiert werden. Wie es erkennbar ist, gelangt nur ein geringer Anteil der Ladungsträger, die tiefer als 2 μm erzeugt werden, zu den HF-Diodenfingern 400a-400f, so daß der Photostrom bei denselben im wesentlichen aus Driftstrom besteht, was eine Geschwindigkeitsverbesserung im Vergleich zu nicht durch umliegende LF-Dioden abgeschirmten HF-Dioden darstellt, da, wie im vorhergehenden erwähnt, tiefer generierte Ladungsträger aufgrund ihres langen Diffusionsweges einen langen Zeitversatz zwischen Generation und Detektion erzeugen. Der Grund für den geringen Diffusionsstrom besteht darin, daß die LF-Dioden 402a und 402b die meisten Minoritätsladungsträger unterhalb einer Tiefe von 2 μm unterhalb der Si/SiO$_2$-Oberfläche abziehen. Lediglich der mittlere Teil 408 unterhalb der HF-Dioden 400a-400f fängt Ladungsträger ein, die in tieferen Regionen erzeugt wurden. Wie es ferner zu erkennen ist, wird es wirksam unterbunden, daß Ladungsträger zu benachbarten n$^+$-HF-Diodenfingern benachbarter HF-Dioden diffundieren, so daß eine gute Übersprechtrennung erzielt wird.

Aus den obigen Betrachtungen ergibt sich ein weiterer Vorteil durch die "Absaugung" des Diffusionsstromes durch die LF-Dioden, die die HF-Dioden durch ihre Kreuzstruktur umgeben. Beachtet man, daß die Eindringtiefe des Lichtes für die Wellenlänge von 405 nm, die Wellenlänge zukünftiger optischer Speichersysteme; 0,196 μm, für Licht der Wellenlänge von 650 nm, der Betriebswellenlänge von DVD-Geräten, 2,89 μm und von Licht der Wellenlänge mit 780 nm, der Betriebswellenlänge von CD-ROM-Geräten, 8,0 μm beträgt, so ist aus der Simulation von Fig. 4 zu erkennen, daß durch Bestrahlung mit Wellenlängen von 650 nm und 780 nm die erzeugten Ladungsträger nicht zu dem Photostrom der HF-Diodenfinger 400a-400f beitragen. Folglich ist bei fester Lichtleistung der Betrag an Photostrom der HF-Dioden weniger empfindlich für die jeweilige Wellenlänge des Lichts. Als ein Ergebnis hat das Vorhandensein der LF-Dioden in der oben beschriebenen n$^-$-Wannenform eine linearisierenden Effekt bezüglich der spektralen Antwort der HF-Dioden. Dieser Linearisierungseffekt geht auch aus Fig. 8 hervor, die einen Graphen zeigt, in der die spektrale Antwort der LF-Dioden (angezeigt mit kleinen Quadraten) und HF-Dioden (angezeigt mit kleinen Kreuzchen) über die Wellenlänge aufgetragen ist. Beide Kurven stellen die spektrale Antwort der HF- bzw. LF-Dioden in dem Fall der gleichzeitigen Auslese dieser Dioden dar, wie es während der Betriebes der optischen Abtastvorrichtung von Fig. 2a und 2b der Fall ist. Wie es zu erkennen ist, zeigen die LF-Dioden das typische spektrale Antwortverhalten von Photodioden: da im allgemeinen die Rekombinationsrate von Ladungsträgern an der Oberfläche höher als bei tiefer generierten Ladungen ist, steigt die spektrale Antwort bzw. Empfindlichkeit bzw. Sensitivität der Dioden bei steigender Wellenlänge an. Ab einer gewissen Wellenlänge, die im vorliegenden Fall etwa 650 nm beträgt, erreichen jedoch die diffundierenden Ladungsträger aufgrund der Tatsache, daß die Eindringtiefe von Licht in das Halbleitersubstrat mit der Wellenlänge ansteigt, die Raumladungszone der LF-Dioden nicht mehr bevor sie rekombinieren. Folglich erfolgt ab 650 nm ein Abfall der Sensitivität für größere Wellenlängen. Die Kennkurve der HF-Dioden unterscheidet sich jedoch grundlegend von derjenigen der LF-Dioden. Wie es zu erkennen ist, zeigen dieselben lediglich einen leichten Anstieg von 0,008 A/W in der Region von 400 nm bis 460 nm. Von 460 nm bis 700 nm bleibt die Sensitivität der HF-Dioden nahezu konstant und fällt in dem Intervall von 700 nm bis 800 nm um lediglich 0,21 A/W ab. Beachtet man, daß die Verstärkung eines Transimpedanzverstärkers, der, wie es im vorhergehenden bereits öfter erwähnt und im folgenden näher beschrieben werden wird, zur Auslese der HF-Dioden verwendet wird, mit aktiver Rückkopplung üblicherweise Schwankungen von ± 5% aufgrund von Nichtlinearitäten der zu seinem Aufbau verwendeten Transistoren ausgesetzt ist, die zum Teil in der Triodenregion verwendet werden, kann die spektrale Antwort der HF-Dioden nahezu als linear betrachtet werden. Dies ergibt ein Auslesesystem mit nahezu konstanter Verstärkung für alle Wellenlängen. Aufgrund der rauhen Oberfläche der Fingerdiodenstruktur der HF-Dioden und der sich ergebenden schwankenden Oxiddicke unterbleibt bei den HF-Dioden zudem ein Interferenzphänomen in der Wellenlängenregion von 650 nm bis 800 nm, wie es bei den LF-Dioden der Fall ist, bei denen sich das Interferenzphänomen bei diesen Wellenlängen ein wenig auf die spektrale Antwortfunktion auswirkt. Vorteilhaft an der HF-Diodenstruktur ist, wie es Fig. 8 zu entnehmen ist, ferner, daß die HF-Dioden für Wellenlängen im nahen Ultraviolettbereich, d.h. den Wellenlängen zukünftiger optischer Speichersysteme, eine relativ bessere Sensitivität aufweisen.

Lediglich der Vollständigkeit halber sind in Fig. 6 und 7 noch zwei Graphen gezeigt, die aufgetragen über die Diodenspannung die Kapazität einer einzelnen HF-Diode (Fig. 6) und LF-Diode (Fig. 7) darstellen. Wie es zu sehen ist, reicht die absolute Kapazität der HF-Dioden von 98 Femtofarad bei 3,3 V bis 165 Femtofarad bei 0,1 V. Dies ist ein Bereich von Werten, der unter Verwendung eines Transimpedanzverstärkers zur Auslese einfach ausgelesen werden können. Die Schwankung der Kapazität ist kein Problem, da die Spannung über die Diode durch die Ausleseschaltung konstant gehalten wird. Der Absolutwert der Übergangskapazität der LF-Dioden reicht von 19,7 Femtofarad bis 22,4 Femtofarad in einem Spannungsbereich von 3,3 V bis 1 V, welches den Bereich darstellt, bei dem die Integration des Photostromes in der im folgenden zu beschreibenden Ausleseschaltung von Fig. 11a durchgeführt wird.

Nachdem im vorhergehenden bezugnehmend auf die Fig. 3-8 ein Ausführungsbeispiel für eine Hardwarerealisierung der Diodenanordnung von Fig. 2a,2b beschrieben worden ist, wird im folgenden ein Ausführungsbeispiel für mögliche Ausleseschaltungen der LF- bzw. HF-Dioden bezugnehmend auf die Fig. 9-11 beschrieben, wobei sich Fig. 9 und 10 zunächst auf die Auslese der HF-Dioden beziehen, während sich Fig. 11a mit der Auslese der LF-Dioden beschäftigt.

Fig. 9 zeigt schematisch die Grundkonfiguration der Auslese einer HF-Diode bzw. von zu einem HF-Diodenbereich zusammengeschlossenen bzw. parallel geschalteten HF-Dioden, wobei die auszulesende HF-Diode bzw. HF-Diodenregion mit dem Bezugszeichen 500 angezeigt ist und den Photostrom $I_{ph}$ erzeugt. Die HF-Diode ist zwischen Bezugspotential 502 und einen Eingang eines Transimpedanzverstärkers 504 geschaltet, dessen Aufbau an einem exemplarischen Ausführungsbeispiel bezugnehmend auf Fig. 10 näher erläutert werden wird. Die Impedanz $Z_f(s)$ stellt die Impedanz des Rückkopplungszweiges des Transimpedanzverstärkers 504 dar, während $Z_i(s)$ die Quellenimpedanz darstellt. $U_0$ ist die Ausgangsspannung am Ausgang des Transimpedanzverstärkers 504. Eine Analyse der Grundkonfiguration von Fig. 9 ergibt die Übertragungsfunktion dieser Konfiguration zu

$$\frac{U_0}{I_{ph}} = \frac{A(s)Z_f(s)Z_i(s)}{Z_i(s)\,(A(s) - 1) - Z_f(s)}$$

wobei A(s) die Verstärkung des Transimpedanzverstärkers 504 anzeigt. In dem Fall eines idealen Verstärkers mit unendlicher Verstärkung ergibt diese Gleichung $U_0 = Z_f(s)\,I_{ph}$, was zeigt, daß der Photostrom $I_{ph}$ mit dem Faktor $Z_f(s)$ in eine Spannung umgewandelt wird.

In dem Fall, daß eine CMOS-Technologie zur Implementierung verwendet wird, kann $Z_f(s)$ als ein Ohmscher Widerstandswert $R_f$ betrachtet werden, während $Z_i(s)$ als kapazitiver Wert betrachtet werden kann, der sich aus der Gate-Kapazität $C_g$ eines Eingangstransistors des Transimpedanzverstärkers und der Übergangs- bzw. Grenzflächenkapazität der HF-Diode 500 $C_d$ zusammensetzt. s ist eine Variable für die Auslesefrequenz. Unter der Annahme daß der Transimpedanzverstärker 504 eine ausreichend hohe Bandbreite aufweist, d.h. A(s) = A, und unter den obigen Annahmen bzw. Betrachtungen ergibt sich die letztgenannte Formel zu

$$\frac{U_0}{I_{ph}} = \frac{AR_f}{(A - 1)\left(1 - \dfrac{s(C_g + C_d)R_f}{A - 1}\right)}$$

Aus dieser Gleichung ergibt sich die -3dB-Bandbreite zu

$$f_{-3dB} = \frac{1 - A}{2\pi(C_g + C_d)R_f}$$

Die letzte Gleichung zeigt, daß die -3dB-Bandbreite der HF-Auslese hauptsächlich durch drei Parameter bestimmt ist: die -3dB-Bandbreite steigt mit dem Betrag der Verstärkung A, wobei A aus Stabilitätsgründen negativ sein muß. Zudem fällt die -3dB-Bandbreite mit steigendem Rückkopplungswiderstandswert oder Eingangskapazität. Ein Rückkopplungswiderstandswert von 63 kΩ und ein Spannungsverstärkungswert von 30 ergibt beispielsweise eine Bandbreite von 142 MHz.

Fig. 10 zeigt ein Ausführungsbeispiel des Transimpedanzverstärkers 504, der vorliegend ein einendiger Eingangsverstärker ist, der verglichen mit einem Standardoperationsverstärker, wie er in den meisten optischen Pickup-Einheiten verwendet wird, aufgrund der geringeren Eingangstransistoranzahl ein besseres Rauschverhalten aufweist. Der Transimpedanzverstärker von Fig. 10 umfaßt drei Verstärkungszweige 600, 602 und 604 und einen Rückkopplungsweg 606. Jeder der Verstärkungszweige 600-604 ist bis auf Parametergrößen der Bauelemente identisch aufgebaut, weshalb im folgenden der Aufbau lediglich in Hinblick auf den ersten Verstärkungszweig 600 beschrieben wird.

In der ersten Verstärkungsstufe befindet sich ein pMOS-Transistor $M_2$, dessen Gate mit dem Vorspannungsanschluß $v_{bias}$ und dessen Source-(Drain-) Anschluß mit Versorgungsspannungspotential 606 verbunden ist. Die zweite Verstärkungsstufe besteht aus zwei nMOS-Transistoren $M_1$ und $M_3$. Der Gate-Anschluß des Transistors $M_1$ ist mit einem Eingang $I_{in}$ des Transimpedanzverstärkers verbunden. Der Drain- (oder Source-) Anschluß des Transistors $M_2$ ist mit dem Drain- (oder Source-) Anschluß des Transistors $M_1$ sowie mit dem Gate- und dem Drain- (oder Source-) Anschluß des Transistors $M_3$ verbunden. Der Source-Anschluß der nMOS-Transistoren $M_1$ und $M_3$ sind mit Masse bzw. Bezugspotential 608 verbunden. Der Drain-Anschluß des Transistors $M_2$ ist ferner mit dem Gate-Anschluß des Transistors $M_1'$ der darauffolgenden Verstärkungsstufe 602 verbunden. Auf ähnliche Weise ist der Drain-Anschluß des Transistors $M_2'$ der zweiten Verstärkungsstufe 602 mit dem Gate-Anschluß des Transistors $M_1''$ der dritten Verstärkungsstufe 604 verbunden. Der Drain-Anschluß des pMOS-Transistors $M_2''$ der dritten Verstärkerstufe ist über den Rückkopplungsweg 606 mit dem Eingang $I_{in}$ verbunden. In den Rückkopplungsweg 606 ist eine Source/Drain-Strecke eines pMOS-Transistors $M_4$ und eines nMOS-Transistors $M_5$ geschaltet. Der Gate-Anschluß des pMOS-Transistors $M_4$ ist mit Masse verbunden, während der Gate-Anschluß des nMOS-Transistors $M_5$ mit einem Anschluß $R_{f\_}$control des Transimpedanzverstärkers verbunden ist. Der Drain-Anschluß des pMOS-Transistors $M_2''$ der dritten Verstärkerstufe ist ferner mit einem Ausgang $V_{out}$ des Transimpedanzverstärkers verbunden, an dem die Ausgangsspannung $U_0$ (siehe Fig. 9) anliegt.

Um die Transistoren in Sättigung für größere Eingangsströme am Eingang $I_{in}$ zu halten, kann die zweite Verstärkungsstufe 602 gegenüber den anderen Verstärkungsstufen 600 und 604 bezüglich bauelementespezifischer Parameter, wie z.B. der Gatelänge, verändert sein. Da die parasitäre Kapazität eines Ohmschen Rückkopplungswiderstandswertes die Bandbreite des Systems erheblich vermindert, wurde statt dessen eine aktive Rückkopplung durch die Transistoren $M_5$ und $M_4$ gewählt. Der tatsächliche Betrag des Widerstandswertes wird durch die Spannung an dem Eingang $R_{f\_}$control über den nMOS-Transistor $M_5$ eingestellt. Der pMOS-Transistor $M_4$ dient zur Linearisierung.

Es wird darauf hingewiesen, daß sich an dem Ausgang des Transimpedanzverstärkers V_out ein Spannungsverstärker anschließen kann, um die Ausgangsspannung $U_0$ (siehe Fig. 9) zu verstärken, um einen ausreichenden Spannungshub zu erhalten, und die Signale von beispielsweise dem CMOS-Chip zu treiben. Hierbei sollte vorteilhafterweise die Bandbreite dieses anschließenden Spannungsverstärkers derart gewählt sein, daß er die -3dB-Bandbreite der HF-Auslese, die im vorhergehenden erörtert wurde, der Transimpedanzverstärkerkonfiguration nicht beeinträchtigt.

Fig. 11a zeigt die LF-Ausleseschaltung zur Auslese der LF-Dioden. Da die Auslese im kHz-Bereich durchgeführt wird, wird ein Integrationslösungsansatz gewählt, wobei insbesondere die Sperrschichtkapazität der LF-Dioden verwendet wird, um den Photostrom zu integrieren.

Es wird zunächst darauf hingewiesen, daß in Fig. 11a nur ein Teil der Ausleseschaltung der LF-Dioden gezeigt ist, der für die Auslese einer LF-Diode zuständig ist, die im folgenden mit dem Bezugszeichen 700 versehen ist, und daß im folgenden zunächst lediglich dieser Teil beschrieben wird. Die LF-Diode 700 ist in Reihe mit einem Schalter S1 in Sperrichtung zwischen ein Versorgungspotential 702 und Masse bzw. Bezugspotential 704 geschaltet. Mit gestrichelten Linien ist in Fig. 11a die Sperrschicht- oder Übergangskapazität $C_d$ der LF-Diode 700 als ein der LF-Diode 700 parallel geschalteter Kondensator ersatzschaltbildmäßig angedeutet. Die Zwischenverbindung zwischen LF-Diode 700 und dem Schalter S1 ist mit einem Gate eines nMOS-Transistors $M_4$ verbunden, dessen Drain-Anschluß wiederum mit Versorgungspotential 704 verbunden ist. Der Source-Anschluß des Transistors $M_4$ ist über einen Schalter S2 mit einem Eingang eines Ausgangsverstärkers 706 verbunden. Zwischen den Eingang des Ausgangsverstärkers 706 und Masse 702 ist ein nMOS-Transistor $M_5$ mit seiner Source/Drain-Strecke geschaltet, während sein Gate-Anschluß mit einem Eingang v_bias verbunden ist. Die Transistoren $M_4$ und $M_5$ bilden bei geschlossenem Schalter S2 zusammen einen Sourcefolger.

Nachdem im vorhergehenden der Aufbau des Teils der Ausleseschaltung für eine LF-Diode 700 beschrieben worden ist, wird im folgenden deren Funktionsweise beschrieben. Die Spannung über die LF-Diode 700 $U_d[i]$ wird zunächst auf die Versorgungsspannung $V_{dd}$ eingestellt, indem der Schalter S1 eingeschaltet wird. Sobald der Schalter S1 offen ist, verringert sich die Spannung $U_d[i]$ über die Grenzflächenkapazität $C_d$ der LF-Diode 700 aufgrund der Entladung der Photodiodenkapazität $C_d$ durch den Photostrom. Für die Abhängigkeit zwischen Spannung $U_d$ und der Zeit gilt:

$$U_d[i] \; = \; V_{DD} \; - \; \frac{1}{C_d} \int\limits_{t_{reset}}^{t} I_{ph}[i]\,(\tau)d\tau$$

wobei angenommen wird, daß die Diodenkapazität $C_d$ unabhängig von $U_d[i]$ ist, $t_{reset}$ den Zeitpunkt angibt, da der Schalter S1 geöffnet wird, t den augenblicklichen Zeitpunkt angibt, und $\tau$ eine Integrationsvariable ist. Es ist ersichtlich, daß der Spannungshub mit Abnahme von $C_d$ steigt. $U_d[i]$ ist die Eingangsspannung zu dem durch den Schalter S2 geschalteten Spannungsfolger aus den Transistoren $M_4$ und $M_5$. Die am Source-Anschluß des Transistors $M_5$ des Spannungsfolgers wird durch den Ausgangsverstärker 706 verstärkt, um die ausgelesene Spannung hinauszutreiben.

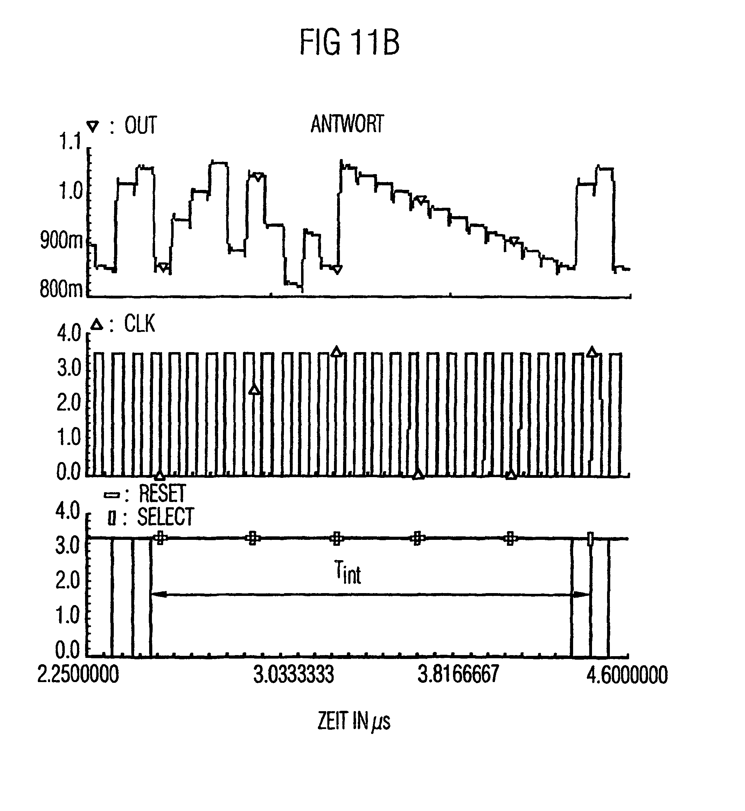

Zur Auslese aller LF-Dioden umfaßt die Ausleseschaltung für jede LF-Diode einen Schalter S1, einen Schalter S2 und einen Transistor $M_4$. Der Schalter S1 und S2 werden durch die Signale reset(i) und select[i] gesteuert. Das Zeitablaufschema für die Signale select und reset ist derart, daß von einem Eingangtakt 25 regulär phasenverschobene Pulse erzeugt werden. Der i-te Puls wird verwendet, um die Diodenspannung der i-ten LF-Photodiode zu dem Ausgangsverstärker 706 für die Länge einer Eingangstaktperiode zu leiten. Der (i+1)-te Puls wird verwendet, um die i-te LF-Photodiode zurückzusetzen. An jede LF-Photodiode des 5x5-LF-Diodenarrays werden folglich kaskadenartig Signale reset und select angelegt, die an jeder 25-ten Taktperiode einen Puls aufweisen, wobei für jede LF-Diode der Puls des reset-Signals unmittelbar auf den Puls des select-Signals folgt. Zwischen dem Rücksetzen jeder LF-Diode und dem Zeitpunkt ihres Auslesens vergehen folglich 23 Taktperioden, wobei während der Auslese bzw. der gemultiplexten Weiterleitung der augenblickliche Photostrome zu dem gespeicherten hinzugefügt wird. Die reset- bzw. select-Signale aller 25 LF-Dioden sind jeweils zueinander um eine Taktperiode versetzt, so daß seriell bzw. kaskadenartig alle 25 LF-Dioden ausgelesen werden. Der Ausgangsverstärker bzw. Ausgangsbuffer ist vorzugsweise so entworfen, daß seine Einschwingzeitdauer kürzer als die halbe Taktperiode ist. Die Taktrate kann beispielsweise 25 MHz betragen. In diesem Fall könnte die fallende Taktflanke verwendet werden, um das Ausgangssignal des Spannungsfolgers abzutasten. Zur Verdeutlichung des Ausleseschemas sind in Fig. 11b in drei untereinander angeordneten Graphen von oben nach unten beispiele für zeitliche Verläufe des Ausgangssignales if_out des Verstärkers 706, eines Takts clk für die Kaskadenmultiplexsteuerung und, in dem untersten Graphen, die reset und select für eine LF-Diode gezeigt.

Durch diesen Multiplex-Auslesebetrieb der LF-Dioden ist gewährleistet, daß für alle LF-Dioden lediglich ein Ausgangsbuffer 706 sowie lediglich ein Pin bzw. nur eine Anschlußfläche bei Implementierung der Optikerfassungsvorrichtung von Fig. 3-11 als integrierte Schaltung erforderlich ist.

Bezugnehmend auf die vorhergehende Beschreibung von Fig. 2-11 wird darauf hingewiesen, daß die Diodenanordnung von Fig. 2a mit einer oder mehreren oder allen der Einrichtungen von Fig. 2a zu einer Optikerfassungseinrichtung in Form von beispielsweise einem Chip integriert sein kann.

Bezugnehmend auf die vorhergehende Beschreibung wird darauf hingewiesen, daß an die beschriebenen Leitfähigkeitstypen, d.h. n-leitend und p-leitend, auch umgedreht werden könnten, und daß ferner auch andere Anordnungen der LF-Dioden als Array möglich sind.

## Patentansprüche

1. Optikerfassungsvorrichtung zum Erfassen einer Intensität eines Lichtstrahls in einem Erfassungsfenster (15; 256) und zum Erfassen von durch den Lichtstrahl übertragenen Daten, mit

 einem Array (250) mit einer Mehrzahl von ersten Erfassungsdioden (251a-254d) in dem Erfassungsfenster (256) ;
 einem Array mit einer Mehrzahl von zweiten Erfassungsdioden (201a-205e) in dem Erfassungsfenster (256);
 einer ersten Ausleseschaltung (600), die mit den ersten Erfassungsdioden (251a-254d) verbindbar ist, zum Auslesen der ersten Erfassungsdioden (251a-254d) mit einer ersten Auslesegeschwindigkeit, um die Daten zu erfassen; und
 einer zweiten Ausleseschaltung (30), die mit den zweiten Erfassungsdioden (201a-205e) verbindbar ist, zum Auslesen der zweiten Erfassungsdioden (201a-205e) mit einer zweiten Auslesegeschwindigkeit, die kleiner als die erste Auslesegeschwindigkeit ist, um die Intensität des Lichtstrahls zu erfassen, wobei das Array (250) von ersten Erfassungsdioden (251a-259 d) ein nxn-Array ist, und das Array (200) von zweiten Erfassungsdioden (201a-205e) ein (n+1)x(n+1)-Array ist, wobei die beiden Arrays derart angeordnet sind, daß die ersten Erfassungsdioden (251a-251d) in den Zwischenräumen des Arrays von zweiten Erfassungsdioden (201a-205e) angeordnet sind.

2. Optikerfassungsvorrichtung gemäß Anspruch 1 , bei der die Mehrzahl (A, B, C, E, F) von ersten Erfassungsdioden (201a-204e) parallel geschaltet sind, um gemeinsam von einer ersten Auswerteschaltung ausgelesen zu werden.

3. Optikerfassungsvorrichtung gemäß Anspruch 1 oder 2, bei der die Mehrzahl von zweiten Erfassungsdioden parallel geschaltet sind.

4. Optikerfassungsvorrichtung gemäß einem der Ansprüche 1 bis 3, die ferner folgendes Merkmal aufweist:

 eine Auswerteschaltung (270) zum Ermitteln einer Ist-Position des Lichtstrahls aus der in dem Erfassungsfenster (256) erfaßten Intensität des Lichtstrahls an den zweiten Erfassungsdioden (201a-205e).

5. Optikerfassungsvorrichtung gemäß einem der Ansprüche 1 bis 4, bei der die ersten Erfassungsdioden (251a-254d) einen kammartig strukturierten Bereich (310a-313d) mit einer ersten Dotierungsart und eine Wanne (302) mit einer zweiten Dotierungsart aufweisen, in der der kammartige strukturierte Bereich (310a-313d) eingebettet ist.

6. Optikerfassungsvorrichtung gemäß Anspruch 5, bei der der kammartig strukturierte Bereich (310a-313d) einen $n^+$-dotierten Bereich (310a-313d) und die Wanne (302) $p^-$-dotiert ist.

7. Optikerfassungsvorrichtung gemäß Anspruch 5 oder 6, bei der die zweiten Erfassungsdioden (201a-205e) einen $n^-$-dotierten Bereich (201a-205e) aufweisen, die in derselben Wanne (302) gebildet sind.

8. Optikerfassungsvorrichtung gemäß einem der Ansprüche 1 bis 4, bei der das Array (250) von ersten Erfassungsdioden (251a-254d) ein nxn-Array ist, und das Array (200) von zweiten Erfassungsdioden (201a-205e) ein (n+1) x(n+1)-Array ist, wobei die beiden Arrays derart angeordnet sind, daß die ersten Erfassungsdioden (251a-251d) in den Zwischenräumen des Arrays von zweiten Erfassungsdioden (201a-205e) angeordnet sind, und bei der der $n^-$-dotierte Bereich (304a-308e) jeder zweiten Diode in einer Kreuzform mit vier Armen gebildet ist, von denen jeder in einen Bereich zwischen zwei benachbarte erste Erfassungsdioden hineinragt, um dieselben diffusionsstrommäßig zu trennen.

9. Optikerfassungsvorrichtung gemäß einem der Ansprüche 1 bis 8, bei der die erste Ausleseschaltung einen Transimpedanzverstärker (600) aufweist.

10. optikerfassungsvorrichtung gemäß einem der Ansprüche 1 bis 9, bei der die zweite Ausleseschaltung folgendes Merkmal aufweist:

   eine Einrichtung (S1, S2) zum seriellen Verbinden jeder zweiten Erfassungsdiode mit einer Versorgungsspannung (702), um eine Diodenübergangskapazität der zweiten Erfassungsdiode aufzuladen, so daß eine Spannung über die zweite Erfassungsdiode der Versorgungsspannung entspricht, und zum anschließenden Trennen der zweiten Erfassungsdiode von der Versorgungsspannung (702), und zum seriellen Ausgeben der Spannung über jede zweite Erfassungsdioden nach Ablauf einer Integrationszeit nach der Trennung von der Versorgungsspannung.

11. Optische Abtastvorrichtung zum Auslesen einer Spur einer optischen Platte durch Erfassen des von einer Spur reflektierten und gemäß auf der Spur gespeicherten Daten modellierten Lichtstrahls, mit
   einer Optikerfassungsvorrichtung gemäß einem der Ansprüche 1-10; und
   einer Steuereinrichtung (270, 272, 274, 276, 278) zum Ausgeben von Steuersignalen zur Spur- und/oder Fokussteuerung abhängig von der erfaßten. Intensität des Lichtstrahls an den zweiten Erfassungsdioden.

12. Optische Abtastvorrichtung gemäß Anspruch 11, bei der die Steuereinrichtung ferner folgendes Merkmal aufweist:

   einer Einrichtung zum Ermitteln einer Abweichung einer Ist-Position des Lichtstrahls in dem Erfassungsfenster von einer Soll-Position in dem Erfassungsfenster aus der erfaßten Intensität des Lichtstrahls an den zweiten Erfassungsdioden; und

   einer Einrichtung zum Berechnen eines Steuersignals zur Spur- und/oder Fokussteuerung aus der Abweichung, derart, daß die Abweichung reduziert wird.

13. Optische Abtastvorrichtung gemäß Anspruch 11, bei der die ermittelte Abweichung in zwei Dimensionen bestimmt ist.

14. Optische Abtastvorrichtung gemäß einem der Ansprüche 11 bis 13, bei der die Optikerfassungsvorrichtung ferner zwei dritte Dioden und eine dritte Ausleseschaltung, die mit den zwei dritten Dioden verbunden ist, zum Auslesen der dritten Erfassungsdioden, um die Intensität des Lichtstrahls zu erfassen, aufweist, wobei die Steuereinrichtung der optischen Abtastvorrichtung ferner folgende Merkmale aufweist:

   eine Einrichtung zum Ermitteln eines Ausmaßes an gleichzeitiger Auslese zweier benachbarter Spuren aus der erfaßten Intensität des Lichtstrahls an den dritten Dioden; und
   eine Einrichtung zum Bestimmen eines Steuersignales zur Einstellung eines Schwellenwertes zur Digitalisierung der erfaßten Daten aus dem bestimmten Ausmaß, derart, daß Bitfehler bei der Digitalisierung reduziert werden.

**15.** Optische Speichervorrichtung mit

einer optischen Platte mit einer optischen Spur, auf der Daten gespeichert sind;

einer Lichtstrahlerzeugungseinrichtung zum Erzeugen des Lichtstrahls;

einer optischen Abtastvorrichtung gemäß einem der Ansprüche 11 bis 14;

einer Optik zum Fokussieren des Lichtstrahls auf die Spur und zum Leiten eines von der Spur reflektierten Lichtstrahls zu dem Erfassungsfenster der Optikerfassungsvorrichtung;

einem Träger zum Tragen der ersten und zweiten Erfassungsdioden der Optikerfassungsvorrichtung, der Lichtstrahlerzeugungseinrichtung und der Optik; und

einer Servoeinrichtung zum Einstellen eines Abstandes des Trägers zur Spur und einer lateralen Lage des Trägers relativ zur Spur abhängig von den Steuersignalen zur Spur- und Fokussteuerung von der optischen Abtastvorrichtung.

**16.** Verfahren zum Betreiben einer Optikerfassungsvorrichtung zum Erfassen einer Intensität eines Lichtstrahls , in einem Erfassungsfenster (256) und zum Erfassen von durch den Lichtstrahl übertragenen Daten, die ein Array (250) mit einer Mehrzahl ersten Erfassungsdioden (251a-254d) und ein Array mit einer Mehrzahl von zweiten Erfassungsdioden (201a-205e) in dem Erfassungsfenster (15; 256) aufweist, wobei das Array (250) von ersten Erfassungsdioden (251a-254d) ein nxn-Array ist, und das Array (200) von zweiten Erfassungsdioden (201a-205e) ein (n+1)x(n+1)-Array ist, wobei die beiden Arrays derart angeordnet sind, daß die ersten Erfassungsdioden (251a-251d) in den Zwischenräumen des Arrays von zweiten Erfassungsdioden (201a-205e) angeordnet sind, mit folgenden Schritten:

Auslesen der ersten Erfassungsdioden (25; 251a-254d) mit einer ersten Auslesegeschwindigkeit, um die Daten zu erfassen; und

Auslesen der zweiten Erfassungsdioden (21a-24d; 201a-205e) mit einer zweiten Auslesegeschwindigkeit, die kleiner als die erste Auslesegeschwindigkeit ist, um die Intensität des Lichtstrahls zu erfassen.

## Claims

**1.** Optical detection device for detecting an intensity of a light beam in a detection window (15; 256) and for detecting data transmitted by the light beam, comprising

an array (250) with a plurality of first detection diodes (251a-254d) in the detection window (256);

an array with a plurality of second detection diodes (201a-205e) in the detection window (256);

a first readout circuit (600) connectable to the first detection diodes (251a-254d), for reading out the first detection diodes (251a-254d) at a first readout speed to detect the data; and

a second readout circuit (30) connectable to the second detection diodes (201a-205e), for reading out the second detection diodes (201a-205e) at a second readout speed lower than the first readout speed, to detect the intensity of the light beam, wherein the array (250) of first detection diodes (251a-254d) is an nxn array, and the array (200) of second detection diodes (201a-205e) is an (n+1)x(n+1) array, both arrays being arranged such that the first detection diodes (251a-254d) are arranged in the gaps of the array of second detection diodes (201a-205e).

**2.** Optical detection device according to claim 1, wherein the plurality (A, B, C, E, F) of first detection diodes (201a-204e) are connected in parallel to be jointly read out by a first evaluation circuit.

**3.** Optical detection device according to claim 1 or 2, wherein the plurality of second detection diodes are connected in parallel.

**4.** Optical detection device according to any of claims 1 to 3, further comprising:

an evaluation circuit (270) for determining an actual position of the light beam from the intensity, detected in the detection window (256), of the light beam at the second detection diodes (201a-205e).

**5.** Optical detection device according to any of claims 1 to 4, wherein the first detection diodes (251a-254d) have an area (310a-313d) structured in a comb-like manner, with a first kind of doping, and a trough (302) with a second kind of doping, wherein the area (310a-313d) structured in a comb-like manner is embedded.

**6.** Optical detection device according to claim 5, wherein the area (310a-313d) structured in a comb-like manner has an n$^+$-doped area (310a-313d), and the trough (302) is p$^-$-doped.

7. Optical detection device according to claim 5 or 6, wherein the second detection diodes (201a-205e) have an n$^-$-doped area (201a-205e) formed in the same trough (302).

8. Optical detection device according to any of claims 1 to 4, wherein the array (250) of first detection diodes (251a-254d) is an nxn array, and the array (200) of second detection diodes (201a - 205e) is an (n+1)x(n+1) array, wherein the two arrays are arranged such that the first detection diodes (251a-251d) are arranged in the gaps of the array of second detection diodes (201a-205e), and wherein the n$^-$-doped area (304a-308e) of each second diode is formed in a cross shape with four arms, each of which projects into an area between two adjacent first detection diodes to separate them in terms of diffusion current.

9. Optical detection device according to any of claims 1 to 8, wherein the first readout circuit comprises a transimpedance amplifier (600).

10. Optical detection device according to any of claims 1 to 9, wherein the second readout circuit comprises:

a means (S1, S2) for serially connecting every second detection diode to a supply voltage (702) to charge a diode junction capacitance of the second detection diode so that a voltage across the second detection diode corresponds to the supply voltage, and for subsequently separating the second detection diode from the supply voltage (702), and for serially outputting the voltage across every second detection diode after expiration of an integration period after the separation from the supply voltage.

11. Optical scanning device for reading out a track of an optical plate by detecting the light beam reflected from a track and modeled in accordance with data stored on the track, comprising
an optical detection device according to any of claims 1-10; and
a control means (270, 272, 274, 276, 278) for outputting control signals for tracking and/or focus control depending on the detected intensity of the light beam at the second detection diodes.

12. Optical scanning device according to claim 11, wherein the control means further comprises:

a means for determining a deviation of an actual position of the light beam in the detection window from a target position in the detection window from the detected intensity of the light beam at the second detection diodes; and

a means for calculating a control signal for tracking and/or focus control from the deviation, such that the deviation is reduced.

13. Optical scanning device according to claim 11, wherein the deviation determined is established in two dimensions.

14. Optical scanning device according to any of claims 11 to 13, wherein the optical detection device further comprises two third diodes and a third readout circuit connected to the two third diodes, for reading out the third detection diodes, to detect the intensity of the light beam, the control means of the optical scanning device further comprising:

a means for determining an extent of a simultaneous readout of two adjacent tracks from the detected intensity of the light beam at the third diodes; and

a means for determining a control signal for setting a threshold value for digitalization of the data detected from the extent determined, such that bit errors in the digitalization are reduced.

15. Optical storage device, comprising
an optical plate having an optical track, which has data stored thereon;
a light-beam generation means for generating the light beam;
an optical scanning device according to any of claims 11 to 14;
an optical means for focusing the light beam onto the track and for directing a light beam which has been reflected from the track to the detection window of the optical detection device;
a carrier for carrying the first and second detection diodes of the optical detection device, the light-beam generation means and the optical means; and

a servo-means for setting a distance of a carrier to the track, and a lateral position of the carrier in relation to the track, depending on the control signals for tracking and focus control from the optical scanning device.

16. Method of operating an optical detection device for detecting an intensity of a light beam in a detection window (256) and for detecting data transmitted by the light beam, comprising an array (250) with a plurality of first detection diodes (251a-254d) and an array with a plurality of second detection diodes (201a-205e) in the detection window (15; 256), wherein the array (250) of first detection diodes (251a-254d) is an nxn array, and the array (200) of second detection diodes (201a-205e) is an (n+1)x(n+1) array, both arrays being arranged such that the first detection diodes (251a-254d) are arranged in the gaps of the array of second detection diodes (201a-205e), comprising the following steps:

reading out the first detection diodes (25; 251a-254d) at a first readout speed to detect the data; and

reading out the second detection diodes (21a-24d; 201a-205e) at a second readout speed, smaller than the first readout speed, to detect the intensity of the light beam.


## Revendications

1. Dispositif de détection optique destiné à détecter une intensité d'un faisceau lumineux dans une fenêtre de détection (15 ; 256) et à détecter des données transmises par le faisceau lumineux, avec
   une rangée (250) avec une pluralité de premières diodes de détection (251a à 2S4d) dans la fenêtre de détection (256) ;
   une rangée avec une pluralité de deuxièmes diodes de détection (201a à 205e) dans la fenêtre de détection (256) ;
   un premier circuit de lecture (600) pouvant être relié aux premières diodes de détection (251a à 254d), pour lire les premières diodes de détection (251a à 254d) à une première vitesse de lecture, pour détecter les données ; et
   un deuxième circuit de lecture (30) pouvant être relié aux deuxièmes diodes de détection (201a à 205e), pour lire les deuxièmes diodes de détection (20 la à 205e) à une deuxième vitesse de lecture qui est inférieure à la première vitesse de lecture, pour détecter l'intensité du faisceau lumineux, la rangée (250) de premières diodes de détection (251a à 254d) étant une rangée nxn, et la rangée (200) de deuxièmes diodes de détection (201a à 205e) étant une rangée (n+1) x (n+1), les deux rangées étant disposées de sorte que les premières diodes de détection (251a à 254d) soient disposées dans les espaces intermédiaires de la rangée de deuxièmes diodes de détection (201a à 205e).

2. Dispositif de détection optique selon la revendication 1, dans lequel la pluralité (A, B, C, E, F) de premières diodes de détection (201a à 204e) sont connectées en parallèle, pour être lues ensemble par un premier circuit d'évaluation.

3. Dispositif de détection optique selon la revendication 1 ou 2, dans lequel la pluralité de deuxièmes diodes de détection sont connectées en parallèle.

4. Dispositif de détection optique selon l'une des revendications 1 à 3, présentant, par ailleurs, la caractéristique suivante :

   un circuit d'évaluation (270) destiné à déterminer une position réelle du faisceau lumineux à partir de l'intensité faisceau lumineux détectée dans la fenêtre de détection (256) aux deuxièmes diodes de détection (201a à 205e).

5. Dispositif de détection optique selon l'une des revendications 1 à 4, dans lequel les premières diodes de détection (251a à 254d) présentent une zone structurée en forme de peigne (310a à 313d) avec un premier type de dopage et une cuvette (302) avec un deuxième type de dopage dans laquelle est incorporée la zone structurée en forme de peigne (310a à 313d).

6. Dispositif de détection optique selon la revendication 5, dans lequel la zone structurée en forme de peigne (310a à 313d) est une zone à dopage $n^+$ (310a-313d) et la cuvette (302) est à dopage $p^-$.

7. Dispositif de détection optique selon la revendication 5 ou 6, dans lequel les deuxièmes diodes de détection (201a à 205e) présentent une zone à dopage n⁻ (201a à 205e) formée dans la même cuvette (302).

8. Dispositif de détection optique selon l'une des revendications 1 à 4, dans lequel la rangée (250) de premières diodes de détection (251a à 254d) est une rangée nxn, et la rangée (200) de deuxièmes diodes de détection (201a à 205e) est une rangée (n+1) x (n+1), les deux rangées étant disposées de sorte que les premières diodes de détection (251a à 251d) sont disposées dans les espaces intermédiaires de la rangée de deuxièmes diodes de détection (201a à 205e), et dans lequel la zone à dopage n⁻ (304a à 308e) de chaque deuxième diode est réalisée en forme de croix avec quatre bras, chacun desquels pénétrant dans une zone entre deux premières diodes de détection adjacentes, pour séparer celles-ci en courant de diffusion.

9. Dispositif de détection optique selon l'une des revendications 1 à 8, dans lequel le premier circuit de lecture présente un amplificateur à transimpédance (600).

10. Dispositif de détection optique selon l'une des revendications 1 à 9, dans lequel le deuxième circuit de lecture présente la caractéristique suivante :

   un dispositif (S1, S2) destiné à relier en série chaque deuxième diode de détection à une tension d'alimentation (702), pour charger une capacité de transition de diode de la deuxième diode de détection, de sorte qu'une tension de la deuxième diode de détection corresponde à la tension d'alimentation, et à séparer ensuite la deuxième diode de détection de la tension d'alimentation (702), et à sortir en série la tension sur chaque deuxième diode de détection après écoulement d'un temps d'intégration après la séparation de la tension d'alimentation.

11. Dispositif de balayage optique pour lire une piste d'une plaque optique en détectant le faisceau lumineux réfléchi par une piste et modelé selon les données mémorisées sur la piste, avec
   un dispositif de détection optique selon l'une des revendications 1 à 10 ; et
   un dispositif de commande (270, 272, 274, 276, 278) destiné à sortir des signaux de commande de réglage de piste et/ou de focalisation en fonction de l'intensité du faisceau lumineux détectée aux deuxièmes diodes de détection.

12. Dispositif de balayage optique selon la revendication 11, dans lequel le dispositif de commande présente, par ailleurs, la caractéristique suivante :

   un dispositif destiné à déterminer une déviation d'une position réelle du faisceau lumineux dans la fenêtre de détection par rapport à une position de consigne dans la fenêtre de détection à partir de l'intensité du faisceau lumineux détecté aux deuxièmes diodes de détection ; et
   un dispositif destiné à calculer un signal de commande de réglge de piste et/ou de focalisation à partir de la déviation, de sorte que la déviation soit réduite.

13. Dispositif de balayage optique selon la revendication 11, dans lequel la déviation déterminée est déterminée en deux dimensions.

14. Dispositif de balayage optique selon l'une des revendications 11 à 13, dans lequel le dispositif de détection optique présente, par ailleurs, deux troisièmes diodes et un troisième circuit de lecture relié aux deux troisièmes diodes pour lire les troisièmes diodes de détection, afin de détecter l'intensité du faisceau lumineux, le dispositif de commande du dispositif de balayage optique présentant, par ailleurs, les caractéristiques suivantes
   un dispositif destiné à détecter une mesure de lecture simultanée de deux pistes adjacentes à partir de l'intensité du faisceau lumineux détecté aux troisièmes diodes ; et
   un dispositif destiné à déterminer un signal de commande de réglage d'une valeur de seuil pour la numérisation des données détectées à partir de la mesure déterminée, de sorte que soient réduites les erreurs de bit lors de la numérisation.

15. Dispositif de mémoire optique, avec
   une plaque optique avec une piste optique sur laquelle sont mémorisées des données ;
   un dispositif de génération de faisceau lumineux destiné à générer le faisceau lumineux ;
   un dispositif de balayage optique selon l'une des revendications 11 à 14 ;
   une optique destinée à concentrer le faisceau lumineux sur la piste et à amener un faisceau lumineux réfléchi par la piste vers la fenêtre de détection du dispositif de détection optique ;

un support destiné à porter les premières et deuxièmes diodes de détection du dispositif de détection optique, du dispositif de génération de faisceau lumineux et de l'optique ; et

un dispositif d'asservissement destiné à régler une distance entre un support et la piste et une position latérale du support par rapport à la piste en fonction des signaux de commande de réglage de piste et de focalisation du dispositif de balayage optique.

**16.** Procédé pour faire fonctionner un dispositif de détection optique pour détecter une intensité d'un faisceau lumineux dans une fenêtre de détection (256) et pour détecter des données transmises par le faisceau lumineux, présentant une rangée (250) avec une pluralité de premières diodes de détection (251a à 254d) et une rangée avec une pluralité de deuxièmes diodes de détection (201a à 205e) dans la fenêtre de détection (15 ; 256), la rangée (250) de premières diodes de détection (251a à 254d) étant une rangée nxn, et la rangée (200) de deuxièmes diodes de détection (201a à 205e) étant une rangée (n+1) x (n+1), les deux rangées étant disposées de sorte que les premières diodes de détection (251a à 251d) soient disposées dans les espaces internédiaires de la rangée de deuxièmes diodes de détection (201a à 205e), aux étapes suivantes consistant à :

lire les premières diodes de détection (25 ; 251a à 254d) à une première vitesse de lecture, pour détecter les données ; et

lire les deuxièmes diodes de détection (21a à 24d ; 20 la à 205e) à une deuxième vitesse de lecture qui est inférieure à la première vitesse de lecture, pour détecter l'intensité du faisceau lumineux.

# FIG 1

DATEN-
AUSLESE-
SCHALTUNG
35

AUSLESE-
SCHALTUNG
30

40

45

## FIG 12

## FIG 13

## FIG 2A

# FIG 2B

## FIG 3A

## FIG 3B

EP 1 516 164 B1

FIG 4

EP 1 516 164 B1

FIG 8

FIG 5

FIG 6

FIG 7

27

## FIG 9

$Z_f(S)$

504

A(s)

$I_{ph}$

$Z_i(s)$

$U_0$

500

502 502

502

## FIG 11A

702

IF_OUT

706

RESET[i] — S1

M4   S2

700

$I_{ph}[i]$

$U_d[i]$

$C_d$

SELECT[i]

M5 — V_BIAS

704

## FIG 10

$R_f$_CONTROL

M5

607

M4

606

v_bias

M2   M2'   M2"

V_OUT

i_in

M1   M3   M1'   M3'   M1"   M3"

600   708   602   604

608

# FIG 11B